# EUROPEAN PATENT APPLICATION

(11) **EP 4 790 696 A1**
(43) Date of publication of application: **12.08.2026**
(21) Application number: 26157199.6
(22) Date of filing: 09.02.2026
(51) Int. Cl.: G09G 3/3233, H10K 59/121, H10K 59/131, H10K 59/35

(54) **DISPLAY PANEL INCLUDING ALTERNATE ARRANGEMENT OF PIXEL CIRCUITS AND ELECTRONIC DEVICE INCLUDING THE SAME**

(30) Priority: 11.02.2025 KR 20250017244
(71) Applicant: Samsung Display Co., Ltd., Yongin-si, Gyeonggi-do 17113 (KR)
(72) Inventor: Kim, Dae Hyun, Yongin-si, Gyeonggi-do (KR); Kim, Sung Hwan, Yongin-si, Gyeonggi-do (KR); Park, Hyun Ae, Yongin-si, Gyeonggi-do (KR); Shin, Hey Jin, Yongin-si, Gyeonggi-do (KR); Yang, Min Ki, Yongin-si, Gyeonggi-do (KR); Lee, Jong Min, Yongin-si, Gyeonggi-do (KR); Jin, Chang Kyu, Yongin-si, Gyeonggi-do (KR)
(74) Representative: Gulde & Partner

(57) **Abstract**

A display panel (100) includes a unit structure (UNA) including a first pixel region (PXA1) and a second pixel region (PXA2). A first pixel (PX1) is disposed in the first pixel region (PXA1), and including a first sub-pixel (SPX1) that emits light of a first color, a second sub-pixel (SPX2) that emits light of a second color, and a third sub-pixel (SPX3) that emits light of a third color. A second pixel (PX2) is disposed in the second pixel region (PXA2), and includes the first sub-pixel (SPX1), the second sub-pixel (SPX2), and the third sub-pixel (SPX3). In the unit structure (UNA), the first type of pixel circuit (PXC_A) and the second type of pixel circuit (PXC_B) are arranged alternately, and the first type of pixel circuit (PXC_A) and the second type of pixel circuit (PXC_B) have symmetrical shapes.

## Description

### TECHNICAL FIELD

The present disclosure relates to a display panel and, more specifically, to a display panel including an alternate arrangement of pixel circuits and an electronic device including the same.

### DISCUSSION OF THE RELATED ART

With the development of the information-oriented society, there is increasing demand for display devices including display panels capable of displaying images in diverse ways. As a result, a wide range of display technologies are being developed to meet these needs. A display device may function as a standalone product or may be integrated into an electronic device.

### SUMMARY

According to an aspect, a display panel (display device) includes a unit structure including a first pixel region and a second pixel region sequentially arranged in a first direction. A first pixel is disposed in the first pixel region, and includes a first sub-pixel that includes a first pixel circuit of a first type and emits light of a first color, a second sub-pixel that includes a second pixel circuit of a second type and emits light of a second color, and a third sub-pixel that includes a third pixel circuit of the first type and emits light of a third color. A second pixel is disposed in the second pixel region, and includes a first sub-pixel that includes a first pixel circuit of the first type and emits light of the first color, a second sub-pixel that includes a second pixel circuit of the second type and emits light of the second color, and a third sub-pixel that includes a third pixel circuit of the second type and emits light of the third color. In the unit structure, the first type of pixel circuit and the second type of pixel circuit are arranged alternately in the first direction, and the first type of pixel circuit and the second type of pixel circuit have symmetrical shapes.

The display panel may further include a power line shared by a pair of the first type pixel circuit and the second type pixel circuit adjacent to each other in the first direction, and the pair of the first type pixel circuit and the second type pixel circuit may have a symmetrical shape with respect to the power line.

The display panel may further include a first data line and a second data line connected to the first type pixel circuit and the second type pixel circuit, respectively, of a pair of the first type pixel circuit and the second type pixel circuit adjacent to each other in the first direction, and may further include a power line disposed between the first data line and the second data line. The first data line and the second data line may face each other with the power line interposed therebetween.

Each of the first sub-pixels of the first pixel and the second pixel may further include a light emitting element of the first color, which emits the light of the first color. Each of the second sub-pixels of the first pixel and the second pixel may further include a light emitting element of the second color, which emits the light of the second color. Each of the third sub-pixels of the first pixel and the second pixel may further include a light emitting element of the third color, which emits the light of the third color.

The light of the first color may be red light, the light of the second color may be green light, and the light of the third color may be blue light.

A change in an amount of luminance of each of the third sub-pixels of the first pixel and the second pixel, according to a change in driving current, may be smaller than a change in an amount of luminance of each of the first sub-pixels and the second sub-pixels of the first pixel and the second pixel, according to a change in driving current.

The pixel circuits of the first pixel and the second pixel may be arranged in the first direction.

An order of arrangement of the first pixel circuit of the first type and the second pixel circuit of the second type of the first pixel may be different from an order of arrangement of the first pixel circuit of the first type and the second pixel circuit of the second type of the second pixel.

The third pixel circuit of the first type of the first pixel may be adjacent to the second pixel circuit of the second type of the second pixel.

An order of arrangement of the first pixel circuit of the first type and the second pixel circuit of the second type of the first pixel may be the same as an order of arrangement of the first pixel circuit of the first type and the second pixel circuit of the second type of the second pixel.

The third pixel circuit of the first type of the first pixel and the third pixel circuit of the second type of the second pixel may be adjacent to each other.

In the first pixel region, the first pixel circuit of the first type, the second pixel circuit of the second type, and the third pixel circuit of the first type may be sequentially arranged along the first direction, and in the second pixel region, the second pixel circuit of the second type, the first pixel circuit of the first type, and the third pixel circuit of the second type may be sequentially arranged along the first direction.

In the first pixel region, the first pixel circuit of the first type, the second pixel circuit of the second type, and the third pixel circuit of the first type may be sequentially arranged along the first direction, and in the second pixel region, the third pixel circuit of the second type, the first pixel circuit of the first type, and the second pixel circuit of the second type may be sequentially arranged along the first direction.

The display panel may further include data lines electrically connected to the first type of pixel circuits and the second type of pixel circuits, and may further include a first wire disposed between a pair of data lines adjacent in the first direction among the data lines.

The display panel may further include a pair of first power lines connected to a pair of the first type pixel circuit and the second type pixel circuit adjacent to each other in the first direction, and may further include a second wire disposed between the pair of first power lines.

Each of the first type of pixel circuits and the second type of pixel circuits may include a transistor and a capacitor.

According to another aspect, an electronic device includes a display module including a display panel (e.g., a display panel according to the present disclosure), a memory storing an image data signal or input control signal, and a processor transmitting the image data signal or input control signal stored in the memory to the display module. The display panel includes a unit structure including a first pixel region and a second pixel region sequentially arranged in a first direction, a first pixel disposed in the first pixel region, and including a first sub-pixel that includes a first pixel circuit of a first type and emits light of a first color, a second sub-pixel that includes a second pixel circuit of a second type and emits light of a second color, and a third sub-pixel that includes a third pixel circuit of the first type and emits light of a third color. A second pixel is disposed in the second pixel region, and includes a first sub-pixel that includes a first pixel circuit of the first type and emits light of the first color, a second sub-pixel that includes a second pixel circuit of the second type and emits light of the second color, and a third sub-pixel that includes a third pixel circuit of the second type and emits light of the third color. In the unit structure, the first type of pixel circuits and the second type of pixel circuits are arranged alternately in the first direction, and the first type of pixel circuits and the second type of pixel circuits have symmetrical shapes.

The display panel may further include data lines electrically connected to the sub-pixels of the first pixel and the second pixel and arranged in the first direction, and the processor may transmit image data signals rearranged in an order corresponding to an arrangement order of the data lines to the display module.

The display panel may further include a power line shared by a pair of the first type pixel circuit and the second type pixel circuit adjacent to each other in the first direction.

The display panel may further include a first data line and a second data line connected to the first type pixel circuit and the second type pixel circuit, respectively, of a pair of the first type pixel circuit and the second type pixel circuit adjacent to each other in the first direction, and may include a power line disposed between the first data line and the second data line, and the first data line and the second data line may face each other with the power line interposed between the first data line and the second data line.

In the first pixel region, the first pixel circuit of the first type, the second pixel circuit of the second type, and the third pixel circuit of the first type may be sequentially arranged along the first direction, and in the second pixel region, the second pixel circuit of the second type, the first pixel circuit of the first type, and the third pixel circuit of the second type may be sequentially arranged along the first direction.

In the first pixel region, the first pixel circuit of the first type, the second pixel circuit of the second type, and the third pixel circuit of the first type may be sequentially arranged along the first direction, and in the second pixel region, the third pixel circuit of the second type, the first pixel circuit of the first type, and the second pixel circuit of the second type may be sequentially arranged along the first direction.

The display panel may further include data lines electrically connected to the sub-pixels of the first pixel and the second pixel and arranged in the first direction, and may further include data connection lines connected between the data lines and a display driver, and some of the data connection lines may intersect each other.

According to yet another aspect, an electronic device includes a display module including a display panel including first sub-pixels emitting light of a first color, second sub-pixels emitting light of a second color, and third sub-pixels emitting light of a third color, a memory storing an image data signal or an input control signal, and a processor transmitting the image data signal or the input control signal stored in the memory to the display module. The first sub-pixels include respective transistors including active layers having a same shape in each of the first sub-pixels. The second sub-pixels include respective transistors including active layers having the same shape in each of the second sub-pixels and having a different shape from the active layers included in the first sub-pixels. One third sub-pixel, among the third sub-pixels, includes transistors including active layers having the same shape as the active layers included in each of the first sub-pixels, and another third sub-pixel, among the third sub-pixels, includes transistors including active layers having the same shape as the active layers included in each of the second sub-pixels.

The transistors included in one of the first sub-pixels, the transistors included in one of the second sub-pixels, the transistors included in the one third sub-pixel, the transistors included in another of the second sub-pixels, the transistors included in another of the first sub-pixels, and the transistors included in the other third sub-pixel may be arranged sequentially in a first direction.

The active layers of the transistors included in the one first sub-pixel and the active layers of the transistors included in the one second sub-pixel may have opposite (i.e., mirror symmetry) shapes in the first direction. The active layers of the transistors included in the one third sub-pixel and the active layers of the transistors included in the other second sub-pixel may have opposite shapes in the first direction. The active layers of the transistors included in the other first sub-pixel and the active layers of the transistors included in the other third sub-pixel may have opposite shapes in the first direction.

The transistors included in the one third sub-pixel and the transistors included in the other third sub-pixel may be arranged sequentially in the first direction.

The active layers of the transistors included in the one third sub-pixel and the active layers of the transistors included in the other third sub-pixel may have opposite shapes in the first direction.

The transistors included in one of the first sub-pixels and the transistors included in one of the second sub-pixels may be arranged sequentially in the first direction, and the transistors included in another of the first sub-pixels and the transistors included in another of the second sub-pixels may be arranged sequentially in the first direction.

The active layers of the transistors included in the one first sub-pixel and the active layers of the transistors included in the one second sub-pixel may have opposite shapes in the first direction, and the active layers of the transistors included in the other first sub-pixel and the active layers of the transistors included in the other second sub-pixel may have opposite shapes in the first direction.

The transistors included in two sub-pixels among the first sub-pixels, the second sub-pixels and the third sub-pixels may be sequentially arranged in a first direction, and the display panel may further include a power line overlapping the transistors included in the two sub-pixels.

The display panel may further include data lines electrically connected to the first sub-pixels, the second sub-pixels and the third sub-pixels and arranged in a first direction, and may further include data connection lines connected between the data lines and a display driver, and some of the data connection lines may intersect each other.

The display panel may further include data lines electrically connected to the first sub-pixels, the second sub-pixels and the third sub-pixels and arranged in a first direction, and the processor may transmit image data signals rearranged in an order corresponding to an arrangement order of the data lines to the display module.

The display panel and the electronic device, according to embodiments, may include pixels including respective pixel circuits. The pixels, according to embodiments, may include pixel circuits of a first type and pixel circuits of a second type, and the pixel circuits of the first type and the pixel circuits of the second type may be alternately arranged in a first direction.

In some embodiments, a pair of the first type pixel circuit and the second type pixel circuit adjacent to each other in the first direction may share one power line. In some embodiments, sub-pixels emitting light of any one color may include two types of pixel circuits, and in the sub-pixels emitting light of other colors, the sub-pixels emitting light of the same color may include pixel circuits of the same type.

According to embodiments, it is possible to improve or optimize the design structure of the backplane layer in which the pixel circuits are disposed, and it is also possible to make the emission characteristics of the pixels uniform and improve the image quality.

However, effects according to the embodiments of the present disclosure are not necessarily limited to those exemplified above and various other effects are incorporated herein.

All embodiments described in this specification may be advantageously combined with one another to the extent that their respective features are compatible. In particular, the expressions "according to an embodiment," "in an embodiment," "an embodiment of the invention provides" etc. mean that the respective features may or may not be part of specific embodiments of the present invention.

### BRIEF DESCRIPTION OF THE DRAWINGS

The above and other aspects and features of the present disclosure will become more apparent by describing in detail embodiments thereof with reference to the attached drawings, in which:
FIG. 1 is a perspective view illustrating a display device according to an embodiment of the present disclosure;
FIG. 2 is a perspective view illustrating a display module according to an embodiment of the present disclosure;
FIG. 3 is a cross-sectional view illustrating a display module according to an embodiment of the present disclosure;
FIG. 4 is a plan view illustrating a display area of a display panel according to an embodiment of the present disclosure;
FIG. 5 is an equivalent circuit diagram illustrating a sub-pixel according to an embodiment of the present disclosure;
FIG. 6 is a cross-sectional view illustrating a display panel according to an embodiment of the present disclosure;
FIG. 7 is a plan view showing a backplane layer of a display panel according to an embodiment of the present disclosure;
FIG. 8 is a plan view showing a backplane layer of a display panel according to an embodiment of the present disclosure;
FIG. 9 is a plan view showing a backplane layer of a display panel according to an embodiment of the present disclosure;
FIG. 10 is a plan view showing a backplane layer of a display panel according to an embodiment of the present disclosure;
FIG. 11 is a plan view showing a first type pixel circuit and a second type pixel circuit according to an embodiment of the present disclosure;
FIG. 12 is a graph showing characteristics of light emitting elements that may be included in a pixel according to an embodiment of the present disclosure;
FIG. 13 is a plan view showing data lines and first power lines according to an embodiment of the present disclosure;
FIG. 14 is a plan view showing data lines, first power lines, and first wires according to an embodiment of the present disclosure;
FIG. 15 is a plan view showing data lines, first power lines, and second wires according to an embodiment of the present disclosure;
FIG. 16 is a plan view showing data lines, first power lines, first wires, and second wires according to an embodiment of the present disclosure;
FIG. 17 is a block diagram of an electronic device according to an embodiment of the present disclosure;
FIG. 18 is a perspective view of electronic devices according to various embodiments;
FIG. 19 is a plan view schematically showing a connection structure of a display driver and data lines according to an embodiment of the present disclosure;
FIG. 20 is a table illustrating a method of transmitting an image data signal according to an embodiment of the present disclosure; and
FIG. 21 is a table illustrating a method of transmitting an image data signal according to an embodiment of the present disclosure.

### DETAILED DESCRIPTION OF THE EMBODIMENTS

The present invention will now be described more fully hereinafter with reference to the accompanying drawings, in which embodiments of the invention are shown. This invention may, however, be embodied in different forms and should not necessarily be construed as limited to the embodiments set forth herein. Rather, these embodiments are provided so that this disclosure will be thorough and complete, and will fully convey the technical scope of the invention as defined by the appended claims to those skilled in the art.

It will also be understood that when an element or a layer is referred to as being "on" another element or layer, it can be directly on the other element or layer, or intervening layers may also be present. The same reference numbers may indicate the same components throughout the specification and the drawings.

It will be understood that, although the terms "first," "second," etc. may be used herein to describe various elements, these elements should not necessarily be limited by these terms. These terms are used to distinguish one element from another element. For instance, a first element discussed below could be termed a second element without departing from the teachings of the present invention. Similarly, the second element could also be termed the first element.

Features of each of various embodiments of the present disclosure may be partially or entirely combined with each other and may technically variously interwork with each other, and respective embodiments may be implemented independently of each other or may be implemented together in association with each other.

Embodiments of the present disclosure relate to a display device, such as an OLED or similar light-emitting display, featuring a novel configuration of pixel circuits that enhances uniformity in pixel emission characteristics and overall display quality. A display panel is provided in which each unit area ("unit structure") contains two distinct pixel areas arranged sequentially in a horizontal direction. Each pixel is made up of three sub-pixels corresponding to red, green, and blue light. A special circuit architecture is used in which each sub-pixel uses one of two types of pixel circuits. These two types differ structurally (for example, in transistor materials or layout), and are arranged alternately and symmetrically in the display. This layout allows for a balanced and mirrored distribution of electrical characteristics, ensuring consistent light emission across the panel.

One advantage of this configuration is the shared power line between adjacent pixel circuits of different types. The symmetry allows the power line to be centered between them, effectively reducing the number of routing lines and optimizing the use of space within the backplane layer. This simplification of wiring also helps improve electrical performance by reducing parasitic capacitance and resistance variations. Additionally, certain sub-pixels of the same color may use different circuit types, enabling tailored emission control to address non-linearities in current-to-luminance response. As a result, display panels built using this structure can more accurately and uniformly render images, especially in terms of brightness and color fidelity.

At the component level, the pixel circuits include transistors and capacitors designed to manage image data, voltage control, and light emission. The physical layering of these elements may include multiple semiconductor and insulating layers that define the active elements of the circuits. The configuration supports both flexible and rigid substrates, and can accommodate various light-emitting materials such as OLEDs or quantum dots. The electronic device housing this display panel may include additional hardware like memory and processors to handle image data processing. Accordingly, a robust, symmetric, and modular pixel arrangement is provided that is suitable for high-quality, compact, and possibly flexible display applications.

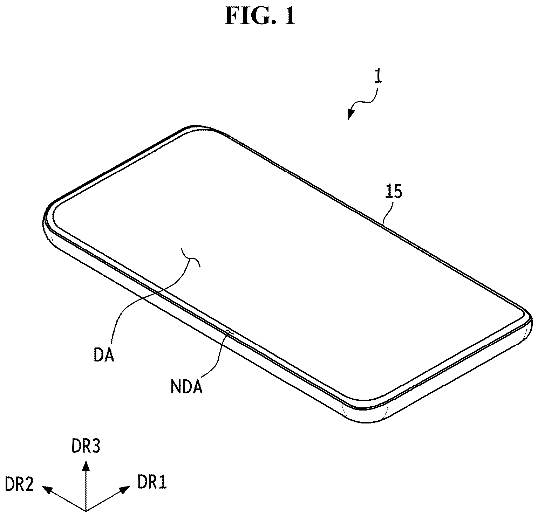

FIG. 1 is a perspective view illustrating a display device according to an embodiment of the present disclosure.

Referring to FIG. 1, a display device 1 may be a device capable of providing (e.g., displaying) an image, such as a moving image or a still image. For example, the display device 1 may be an electronic device 10 that includes a display module 11 for implementing a display screen and thus may display an image. Alternatively, the display device 1 may be included in an electronic device 10 that includes a display panel 100 and may form the display screen of the electronic device 10. As an example, the display device 1 may refer to all electronic devices 10 that provide a display screen on which an image may be displayed or include a display module 11 including a display panel 100 for displaying an image.

In an embodiment of the present disclosure, the display device 1 may be a light emitting display device including a light emitting element LE such as an inorganic light emitting diode (inorganic LED) or an organic light emitting diode (organic LED), but is not necessarily limited thereto. For example, in the present disclosure, a light emitting display device 1 including an organic light emitting diode (organic LED) is disclosed as a display device 1 to which embodiments may be applied, but the type or form of the display device 1 to which embodiments may be applied is not necessarily limited thereto.

In an embodiment of the present disclosure, the display device 1 may further include an additional element in addition to the display module 11. For example, the display device 1 may further include a housing 15 (or a casing) for storing and/or protecting the display module 11.

The display device 1 may have various shapes such as a rectangle, a square, a circle, or the like. The display device 1 may include corner portions having an angled or rounded shape. In FIG. 1, the display device 1 is illustrated as having a roughly rectangular shape on a plane defined by a first direction DR1 and a second direction DR2 and having rounded corner portions. The display device 1 may have a thickness in a third direction DR3 intersecting the first direction DR1 and the second direction DR2.

The display device 1 may include a display area DA and a non-display area NDA. The display area DA is an area where an image can be displayed (e.g., an area including pixels), and the non-display area NDA is an area where an image is not displayed (e.g., an area excluding pixels). The display area DA may also be referred to as an active region, and the non-display area NDA may also be referred to as a non-active region. The display area DA may substantially occupy the center of the display device 1. The non-display area NDA may be disposed around the display area DA. In one example, the non-display area NDA may be disposed at the edge of the display device 1 to surround the display area DA on at least two sides thereof.

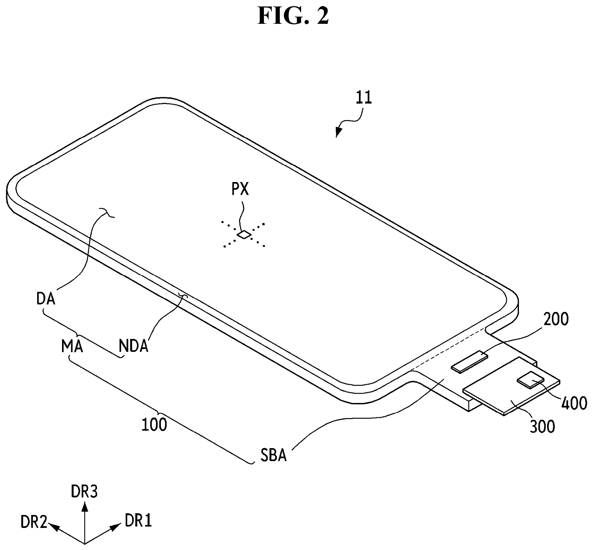

FIG. 2 is a perspective view illustrating a display module according to an embodiment of the present disclosure. For example, FIG. 2 shows an embodiment of the present disclosure of a display module 11 that may be included in the display device 1 of FIG. 1.

Referring to FIGS. 1 and 2, the display device 1 may include the display module 11. The display module 11 may include a display panel 100 for implementing a display screen, and a display driver 200 and a circuit board 300 for driving the display panel 100. In an embodiment of the present disclosure, the display device 1 may provide a touch input function, and the display module 11 may further include a touch driver 400.

The display panel 100 may include a main region MA including the display area DA. The main region MA may further include the non-display area NDA provided around the display area DA.

The pixels PX may be arranged in the display area DA. For example, the display area DA may include pixel regions where the pixels PX are arranged. Each pixel region may include emission areas of sub-pixels constituting each pixel PX. When the display panel 100 is a light emitting display panel including light emitting elements, each sub-pixel may include at least one light emitting element placed in each emission area. Each sub-pixel may further include a pixel circuit for controlling the light emitting element.

Wires connected to the pixels PX may be arranged in the non-display area NDA. For example, wires connecting the pixels PX to the display driver 200 may be arranged in the non-display area NDA. Wires connecting the pixels PX to a pad portion and/or wires connecting the display driver 200 to the pad portion may be further arranged in the non-display area NDA.

In an embodiment of the present disclosure, at least one driving circuit (e.g., a scan driver) for driving the pixels PX may be further placed in the non-display area NDA. The driving circuit of the non-display area NDA may be formed in the backplane layer of the display panel 100 together with the pixel circuits of the pixels PX, but the present disclosure is not necessarily limited thereto.

In an embodiment of the present disclosure, the display panel 100 may further include a sub-region SBA extending from the main region MA. The sub-region SBA may be a region extending from one side of the main region MA. In an embodiment of the present disclosure, the sub-region SBA may have flexible characteristics so as to be bent, folded, or rolled to at least a noticeable extent without cracking or otherwise sustaining damage thereto. When the sub-region SBA is bent (or folded), at least a portion of the sub-region SBA and the main region MA may overlap each other in a thickness direction (e.g., the third direction DR3). For example, when the display device 1 is bent in the sub-region SBA, at least a part of the sub-region SBA including an area where the display driver 200 is disposed and an area where a pad portion connected to the circuit board 300 is disposed may be disposed under the main region MA.

The sub-region SBA may include the display driver 200 and the pad portion. The pad portion may be an area where the pads electrically connected to the circuit board 300 are arranged.

In an embodiment, the sub-region SBA may be omitted, and the pad portion may be disposed in the non-display area NDA of the main region MA. In this case, the display driver 200 may be disposed in the non-display area NDA of the main region MA, or may be disposed on the circuit board 300 connected to the display panel 100. By way of example, the display panel 100 may include the main region MA and the pad portion disposed in the non-display area NDA of the main region MA, and the circuit board 300 may be disposed on the pad portion and electrically connected to the pads of the pad portion. In an embodiment of the present disclosure, the display driver 200 may be placed on the circuit board 300 by a chip on film (COF) method, and may be electrically connected to the display panel 100 through the pad portion.

The display driver 200 may output driving signals for driving the display panel 100. For example, the display driver 200 may supply data voltages to data lines electrically connected to the pixels PX. In an embodiment of the present disclosure, the display driver 200 may further include a power supply circuit that generates driving voltages necessary for driving the pixels PX, and may supply the driving voltages to power lines electrically connected to the pixels PX. In an embodiment of the present disclosure, the display driver 200 may further output driving signals for driving the scan driver. For example, the display driver 200 may supply scan control signals to the scan driver through wires electrically connected to the scan driver formed in the display panel 100. In an embodiment of the present disclosure, the display driver 200 may be formed as an integrated circuit (IC) and mounted on the display panel 100 by a chip on glass (COG) method, a chip on plastic (COP) method, or an ultrasonic bonding method.

The circuit board 300 may be placed on the pad portion of the display panel 100, and may be electrically connected to the display panel 100 through a conductive material (for example, anisotropic conductive film (ACF), etc.). As an example, the circuit board 300 may be attached to the pad portion of the display panel 100 using an anisotropic conductive film (ACF). In an embodiment of the present disclosure, the circuit board 300 may be a flexible printed circuit board, a printed circuit board, or a flexible film such as a chip on film.

The touch driver 400 may be mounted on the circuit board 300. The touch driver 400 may be electrically connected to a touch sensing layer of the display panel 100. In an embodiment of the present disclosure, the touch sensing layer of the display panel 100 may include touch electrodes constituting a capacitive touch sensor. In this case, the touch driver 400 may supply each touch drive signal to touch electrodes of the touch sensing layer, and may detect a touch input by sensing the amount of change in capacitance formed between the touch electrodes. In an embodiment of the present disclosure, the touch driver 400 may be formed as an integrated circuit (IC).

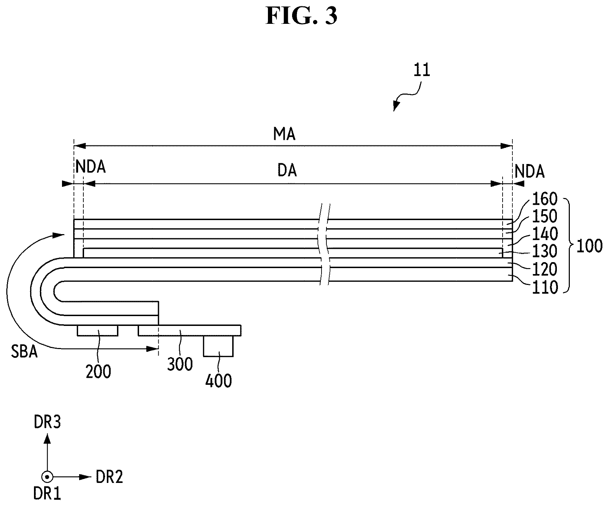

FIG. 3 is a cross-sectional view illustrating a display module according to an embodiment of the present disclosure. For example, FIG. 3 shows an example of a cross-section of the display module 11 in a state where the display panel 100 of FIG. 2 is bent in the sub-region SBA.

Referring to FIGS. 2 and 3, the display panel 100 may include a substrate 110, a backplane layer 120, a light emitting element layer 130, and an encapsulation layer 140 (or a protective layer). In an embodiment of the present disclosure, the display panel 100 may further include a touch sensing layer 150 and an optical layer 160.

The substrate 110 may be a base substrate or a base member. The substrate 110 may be a flexible substrate which can be bent, folded or rolled, to at least a noticeable degree without being damaged but is not necessarily limited thereto. In an embodiment of the present disclosure, the substrate 110 may include a polymer resin such as polyimide (PI). In an embodiment, the substrate 110 may include a glass material or a metal material.

The backplane layer 120 may be disposed on the substrate 110. The backplane layer 120 may include circuit elements, e.g., transistors and capacitors, constituting pixel circuits of the pixels PX. The backplane layer 120 may further include wires. For example, the backplane layer 120 may include signal lines (for example, scan lines, emission control lines, and data lines that transmit scan signals, emission control signals, and data voltages to the sub-pixels of the pixels PX, respectively) electrically connected to the pixels PX and power lines (for example, a plurality of power lines that transmit a plurality of driving voltages to the sub-pixels of the pixels PX).

In an embodiment of the present disclosure, when the display panel 100 includes a scan driver disposed in the non-display area NDA, the backplane layer 120 may further include circuit elements constituting the scan driver and wires (for example, signal lines and power lines that transmit control signals and driving voltages for driving the scan driver) electrically connected to the scan driver.

The backplane layer 120 may be disposed in the display area DA, the non-display area NDA, and the sub-region SBA. The circuit elements constituting the pixel circuits of the pixels PX, and the signal lines and the power lines electrically connected to the pixels PX may be arranged in the display area DA of the backplane layer 120. The signal lines and the power lines of the display area DA may be extended to the non-display area NDA of the backplane layer 120, and each of the signal lines and the power lines may be electrically connected to the scan driver, the display driver 200, the pad of the pad portion, or the like.

The light emitting element layer 130 may be arranged on the backplane layer 120. The light emitting element layer 130 may include light emitting elements arranged in the emission areas of the pixels PX. The light emitting element layer 130 may further include a structure (for example, a pixel defining film or bank) that defines or partitions the emission areas of the pixels PX.

The encapsulation layer 140 may be disposed on the light emitting element layer 130. For example, the encapsulation layer 140 may cover the top surface and the side surface of the light emitting element layer 130 to protect the light emitting element layer 130. In an embodiment of the present disclosure, the encapsulation layer 140 may include at least one inorganic film and at least one organic film for encapsulating the light emitting element layer 130. For example, the encapsulation layer 140 may include a plurality of inorganic encapsulation layers and an organic encapsulation layer interposed between the inorganic encapsulation layers.

The touch sensing layer 150 may be disposed on the encapsulation layer 140. For example, the touch sensing layer 150 may be disposed or formed on the encapsulation layer 140, or may be disposed on a separate substrate disposed on the encapsulation layer 140. The position of the touch sensing layer 150 is not necessarily limited thereto, and may vary according to embodiments. When the display module 11 (or the display device 1) does not provide a touch input function, the display module 11 might not include the touch sensing layer 150. Alternatively, the touch sensing layer 150 may be provided separately from the display panel 100 and may be placed on the display panel 100.

The touch sensing layer 150 may include elements for generating an electrical signal in response to a user's touch input. For example, the touch sensing layer 150 may include touch electrodes arranged in an area providing the touch input function, and touch lines electrically connecting the touch electrodes to the touch driver 400. When the display module 11 provides the touch input function in the display area DA, the touch electrodes may be arranged in the display area DA. The touch lines may be connected to the touch electrodes in the main region MA (for example, the display area DA) where the touch electrodes are arranged. The touch lines may be extended to the sub-region SBA to be electrically connected to the plurality of pads arranged in the pad portion, and may be electrically connected to the touch driver 400 through the plurality of pads. A part of the touch lines arranged in the sub-region SBA may be disposed on the backplane layer 120 or inside the backplane layer 120.

The optical layer 160 may include an element for adjusting and/or improving the optical characteristics of the display panel 100. For example, the optical layer 160 may include at least one of a color filter layer (for example, a color filter layer including color filters corresponding to the emission wavelengths of the sub-pixels included in the pixels PX), a polarizing layer, or an anti-reflection layer. The optical layer 160 may be provided integrally with the display panel 100, but is not necessarily limited thereto. The optical layer 160 may be omitted.

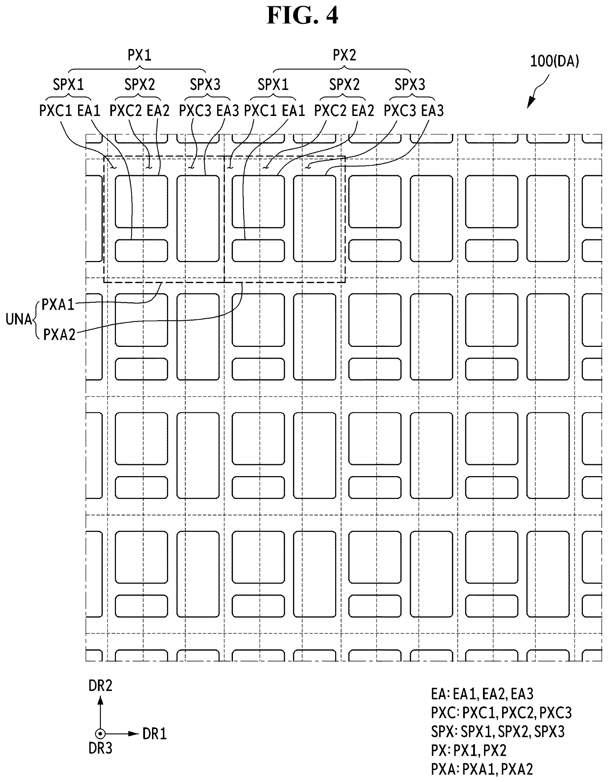

FIG. 4 is a plan view illustrating a display area of a display panel according to an embodiment of the present disclosure. For example, FIG. 4 shows a schematic shape or position of the pixels PX that may be disposed in the display area DA of the display panel 100 according to an embodiment of the present disclosure.

Referring to FIG. 4, the pixels PX may be disposed in the display area DA of the display panel 100. In an embodiment of the present disclosure, the pixels PX may be arranged in a matrix form along the first direction DR1 and the second direction DR2.

The display area DA may include the pixel regions PXA where the respective pixels PX are arranged. For example, the display area DA may include a plurality of pixel regions PXA including a pair of a first pixel region PXA1 and a second pixel region PXA2 adjacent to each other in the first direction DR1. In FIG. 4, an area including two pixel regions PXA including a pair of the first pixel region PXA1 and the second pixel region PXA2 is defined as one unit structure UNA, and the configuration and/or arrangement shape of the pixels PX will be described based on the first pixel PX1 and the second pixel PX2 disposed in the unit structure UNA. The unit structure UNA may also be referred to as "unit pixel region." The display area DA may include a plurality of unit structures UNA in each of the first direction DR1 and the second direction DR2, and the structures and/or shapes of the unit structures UNA may be substantially the same.

Each of the pixels PX may include a plurality of sub-pixels SPX. For example, each of the pixels PX may include a first sub-pixel SPX1, a second sub-pixel SPX2, and a third sub-pixel SPX3.

Each of the sub-pixels SPX may include a pixel circuit PXC and an emission area EA. The pixel circuit PXC may be electrically connected to the emitting element of the corresponding sub-pixel SPX, and may include circuit elements (for example, a plurality of transistors and at least one capacitor) for controlling the light emitting element. The light emitting element of each sub-pixel SPX may be arranged in the emission area EA. The emission area EA may be a light transmitting area through which light generated from the light emitting element of each sub-pixel SPX may transmit.

For example, the first sub-pixel SPX1 may include a first pixel circuit PXC1 and a first emission area EA1. The first pixel circuit PXC1 may refer to the pixel circuit PXC of the first sub-pixel SPX1, and the first emission area EA1 may refer to the emission area EA of the first sub-pixel SPX1. The second sub-pixel SPX2 may include a second pixel circuit PXC2 and a second emission area EA2. The second pixel circuit PXC2 may refer to the pixel circuit PXC of the second sub-pixel SPX2, and the second emission area EA2 may refer to the emission area EA of the second sub-pixel SPX2. The third sub-pixel SPX3 may include a third pixel circuit PXC3 and a third emission area EA3. The third pixel circuit PXC3 may refer to the pixel circuit PXC of the third sub-pixel SPX3, and the third emission area EA3 may refer to the emission area EA of the third sub-pixel SPX3.

In an embodiment of the present disclosure, the sub-pixels SPX of each pixel PX may emit light of different colors. For example, the first sub-pixel SPX1 may emit light of a first color, the second sub-pixel SPX2 may emit light of a second color, and the third sub-pixel SPX3 may emit light of a third color. In an embodiment of the present disclosure, the light of the first color may be red light, the light of the second color may be green light, and the light of the third color may be blue light, but the present disclosure is not necessarily limited thereto. For example, the type, number, ratio, and/or combination of the sub-pixels SPX constituting each pixel PX may vary depending on embodiments. In addition, the color or wavelength of light emitted from each of the sub-pixels SPX forming each pixel PX may vary depending on embodiments.

Each pixel region PXA where each pixel PX is disposed may include pixel circuit areas where the pixel circuits PXC of the corresponding pixel PX are disposed, and the emission areas EA where the light emitting elements of the corresponding pixel PX are disposed. For example, each pixel region PXA may include the plurality of pixel circuit areas including a first pixel circuit area, a second pixel circuit area, and a third pixel circuit area where the first pixel circuit PXC1, the second pixel circuit PXC2, and the third pixel circuit PXC3 are disposed, respectively, and the plurality of emission areas EA including the first emission area EA1, the second emission area EA2, and the third emission area EA3 where the light emitting element (for example, a light emitting element of the first color) of the first sub-pixel SPX1, the light emitting element (for example, a light emitting element of the second color) of the second sub-pixel SPX2, and the light emitting element (for example, a light emitting element of the third color) of the third sub-pixel SPX3 are disposed, respectively. In an embodiment of the present disclosure, the emission areas and the pixel circuit areas of each pixel PX may overlap each other. In this case, the pixels PX may be efficiently disposed in the display area DA, and the light emitting elements and the pixel circuits PXC of each pixel PX may be smoothly or easily connected to one another.

In an embodiment of the present disclosure, the pixel circuits PXC included in each pixel PX may be arranged in one direction. For example, the first pixel circuit PXC1, the second pixel circuit PXC2, and the third pixel circuit PXC3 of each pixel PX may be arranged along the first direction DR1 in each pixel region PXA.

In an embodiment of the present disclosure, the pixel circuits PXC of the pixels PX may be arranged in the same shape or order in each pixel region PXA. For example, the first pixel circuit PXC1, the second pixel circuit PXC2, and the third pixel circuit PXC3 of the first pixel PX1 may be arranged sequentially along the first direction DR1 in the first pixel region PXA1 where the first pixel PX1 is disposed, and the first pixel circuit PXC1, the second pixel circuit PXC2, and the third pixel circuit PXC3 of the second pixel PX2 may be arranged sequentially along the first direction DR1 in the second pixel region PXA2 where the second pixel PX2 is disposed. The first pixel PX1 and the second pixel PX2 may be adjacent to each other in the first direction DR1. In this case, in the unit structure UNA where a pair of pixels PX, for example, the first pixel PX1 and the second pixel PX2, adjacent to each other in the first direction DR1 are disposed, the first sub-pixel SPX1, the second sub-pixel SPX2, and the third sub-pixel SPX3 of the first pixel PX1, and the first sub-pixel SPX1, the second sub-pixel SPX2, and the third sub-pixel SPX3 of the second pixel PX2 may be arranged sequentially along the first direction DR1.

In an embodiment of the present disclosure, the pixel circuits PXC of the pixels PX may be arranged in a stripe shape in the display area DA. For example, the pixel circuits PXC of the sub-pixels SPX that emit light of the same color may be arranged side by side in the second direction DR2. In this case, the first pixel circuits PXC1 of the pixels PX disposed in each pixel column of the display area DA extending in the second direction DR2 may be arranged in the second direction DR2. Similarly, the second pixel circuits PXC2 of the pixels PX disposed in each pixel column may be arranged in the second direction DR2, and the third pixel circuits PXC3 of the pixels PX disposed in each pixel column may be arranged in the second direction DR2.

The emission areas EA and the pixel circuits PXC of the sub-pixels SPX included in each pixel PX may be arranged in the same shape or order, or may be arranged in different shapes or orders. In an embodiment of the present disclosure, as illustrated in FIG. 4, the first emission area EA1 and the second emission area EA2 of each pixel PX may be arranged in the second direction DR2, and the third emission area EA3 may be adjacent to the first emission area EA1 and the second emission area EA2 in the first direction DR1. In an embodiment of the present disclosure, the first emission area EA1 and the second emission area EA2 may overlap different parts of the first pixel circuit PXC1 and the second pixel circuit PXC2, and the third emission area EA3 may overlap the third pixel circuit PXC3. The third emission rea EA3 may overlap a part of the first pixel circuit PXC1 and a part of the second pixel circuit PXC2, but the present disclosure is not necessarily limited thereto. In an embodiment of the present disclosure, the emission areas EA of each pixel PX may have a size that is adjusted or differentiated according to the difference in the emission efficiency of the sub-pixels SPX or the color of the pixel PX. For example, the first emission area EA1, the second emission area EA2, and/or the third emission area EA3 of each pixel PX may have different sizes (for example, different areas).

Although FIG. 4 illustrates an embodiment in which the sub-pixels SPX of each of the pixels PX are disposed or arranged in the same shape, the embodiments are not necessarily limited thereto. For example, in FIG. 4, the pixel circuits PXC of the first pixel PX1 and the second pixel PX2 are arranged in the same shape or order, but the pixel circuits PXC of each of the first pixel PX1 and the second pixel PX2 may be arranged in different shapes or orders. The present disclosure discloses various embodiments related to the arrangement shapes of the pixel circuits PXC, and detailed description will be provided later.

The emission areas EA of each of the first pixel PX1 and the second pixel PX2 may be arranged in the same shape or order, but the present disclosure is not necessarily limited thereto. For example, the emission areas EA of each of the first pixel PX1 and the second pixel PX2 may be arranged in different shapes or orders.

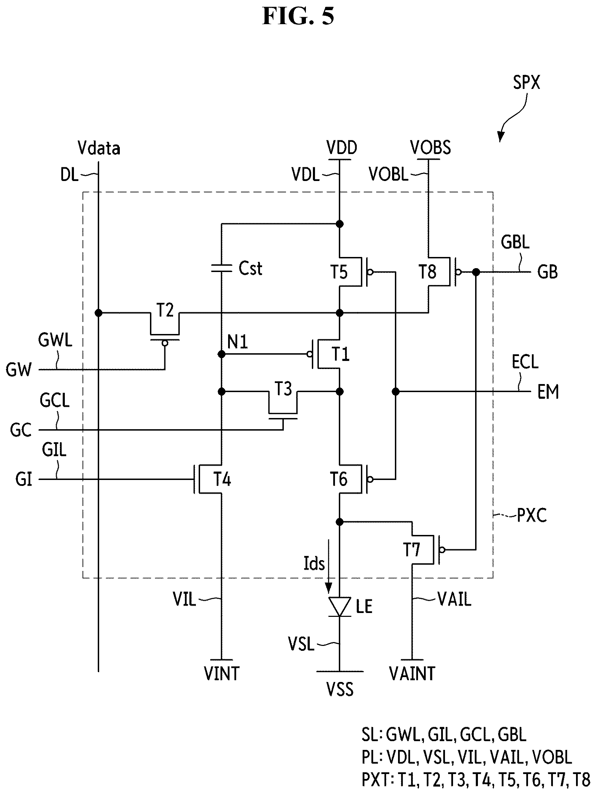

FIG. 5 is an equivalent circuit diagram illustrating a sub-pixel according to an embodiment of the present disclosure. For example, FIG. 5 may be an equivalent circuit diagram showing one sub-pixel SPX among the sub-pixels SPX of FIG. 4. In an embodiment of the present disclosure, the circuit configurations of the sub-pixels SPX constituting each pixel PX may be substantially the same. For example, the equivalent circuit diagrams of the first sub-pixel SPX1, the second sub-pixel SPX2, and the third sub-pixel SPX3 of FIG. 4 may be the same.

Referring to FIG. 5 in addition to FIGS. 1 to 4, the sub-pixel SPX may include a pixel circuit PXC and a light emitting element LE electrically connected to the pixel circuit PXC.

The sub-pixel SPX may be connected to at least one scan driver through the scan lines SL and the emission control line ECL. For example, the sub-pixel SPX may be electrically connected to a scan driver disposed around the display area DA (for example, a part of the non-display area NDA disposed on the left side and/or right side of the display area DA) through a write scan line GWL, an initialization scan line GIL, a control scan line GCL, a bias scan line GBL, and an emission control line ECL. The scan driver may output a write scan signal GW, an initialization scan signal GI, a control scan signal GC, a bias scan signal GB, and an emission control signal EM through the write scan line GWL, the initialization scan line GIL, the control scan line GCL, the bias scan line GBL, and the emission control line ECL, respectively.

The sub-pixel SPX may be connected to the display driver 200 via the data line DL. The display driver 200 may output a data voltage Vdata corresponding to the image data of each frame to the data line DL.

The sub-pixel SPX may be connected to the display driver 200 (or a power supply circuit provided separately from the display driver 200) through power lines PL. For example, the sub-pixel SPX may be connected to the display driver 200 through a first power line VDL, a second power line VSL, a third power line VIL, a fourth power line VAIL, and a fifth power line VOBL. The display driver 200 may supply the first driving voltage VDD, the second driving voltage VSS, the third driving voltage VINT, the fourth driving voltage VAINT, and the fifth driving voltage VOBS to the first power line VDL, the second power line VSL, the third power line VIL, the fourth power line VAIL, and the fifth power line VOBL, respectively. In an embodiment of the present disclosure, the first driving voltage VDD, the second driving voltage VSS, the third driving voltage VINT, the fourth driving voltage VAINT, and the fifth driving voltage VOBS may be a high potential pixel voltage (e.g., an anode voltage), a low potential pixel voltage (e.g., a cathode voltage or common voltage), a first initialization voltage (e.g., a gate initialization voltage), a second initialization voltage (e.g., an anode initialization voltage), and a bias voltage, respectively.

The pixel circuit PXC may control a driving current Ids supplied to the light emitting element LE in response to the driving signals (e.g., the write scan signal GW, the initialization scan signal GI, the control scan signal GC, the bias scan signal GB, the emission control signal EM, and the data voltage Vdata) supplied to the sub-pixel SPX. The emission timing and luminance of the light emitting element LE may be controlled by the pixel circuit PXC.

The pixel circuit PXC may include pixel transistors PXT and a storage capacitor Cst.

In an embodiment of the present disclosure, the pixel transistors PXT may include first to eighth transistors T1 to T8. The first transistor T1 may be a driving transistor of the sub-pixel SPX. The second to eighth transistors T2 to T8 may be switching transistors of the sub-pixel SPX.

In an embodiment of the present disclosure, the sub-pixel SPX may include different types of pixel transistors PXT. For example, the first, second, fifth, sixth, seventh, and eighth transistors T1, T2, T5, T6, T7, and T8 may be P-type transistors (e.g., P-type polycrystalline silicon transistors including active layers containing polycrystalline silicon), and the third and fourth transistors T3 and T4 may be N-type transistors (e.g., N-type oxide transistors including active layers containing an oxide semiconductor). In an embodiment of the present disclosure, the active layers of P-type transistors (e.g., the active layers containing polycrystalline silicon) and the active layers of N-type transistors (e.g., the active layers containing an oxide semiconductor) may be disposed in different layers within the display panel 100 (e.g., a backplane layer of the display panel 100).

The first transistor T1 may be connected between the fifth transistor T5 and the sixth transistor T6. The first transistor T1 may be connected to the first power line VDL via the fifth transistor T5, and may be connected to the light emitting element LE via the sixth transistor T6. The gate electrode of the first transistor T1 may be connected to a first node N1. The first transistor T1 may control the driving current Ids flowing through the sub-pixel SPX according to the voltage of the first node N1 applied to the gate electrode (for example, a voltage corresponding to the data voltage Vdata).

The second transistor T2 may be connected between the data line DL and the first electrode of the first transistor T1 (e.g., the source electrode of the first transistor T1 connected to the fifth transistor T5). The gate electrode of the second transistor T2 may be connected to the write scan line GWL. The second transistor T2 may be turned on by the write scan signal GW of a gate-on voltage (for example, a low-level voltage at which the second transistor T2 can be turned on) supplied from the write scan line GWL. When the second transistor T2 is turned on, the data voltage Vdata supplied from the data line DL may be transmitted to the first electrode (e.g., the source electrode) of the first transistor T1.

The third transistor T3 may be connected between the second electrode of the first transistor T1 (e.g., the drain electrode of the first transistor T1 connected to the sixth transistor T6) and a first node N1. The gate electrode of the third transistor T3 may be connected to the control scan line GCL. The third transistor T3 may be turned on by the control scan signal GC of a gate-on voltage (e.g., a high level voltage at which the third transistor T3 can be turned on) supplied from the control scan line GCL to connect the gate electrode of the first transistor T1 to the second electrode of the first transistor T1. When the third transistor T3 is turned on, the first transistor T1 may be driven as a diode, and a voltage corresponding to the data voltage Vdata may be applied to the first node N1.

The fourth transistor T4 may be connected between the first node N1 and the third power line VIL. The gate electrode of the fourth transistor T4 may be connected to the initialization scan line GIL. The fourth transistor T4 may be turned on by the initialization scan signal GI of a gate-on voltage (e.g., a high level voltage at which the fourth transistor T4 can be turned on) supplied from the initialization scan line GIL to connect the first node N1 to the third power line VIL. When the fourth transistor T4 is turned on, the voltage of the first node N1 may be initialized to the third driving voltage VINT of the third power line VIL.

The fifth transistor T5 may be connected between the first power line VDL and the first electrode of the first transistor T1. The gate electrode of the fifth transistor T5 may be connected to the emission control line ECL (e.g., the first emission control line EL1 or the second emission control line EL2 of FIG. 3). The fifth transistor T5 may be turned on by the emission control signal EM of a gate-on voltage (e.g., a low level voltage at which the fifth transistor T5 can be turned on) supplied from the emission control line ECL to connect the first electrode of the first transistor T1 to the first power line VDL. When the fifth transistor T5 is turned on, the first power line VDL may be connected to the first electrode of the first transistor T1.

The sixth transistor T6 may be connected between the second electrode of the first transistor T1 and the light emitting element LE. The gate electrode of the sixth transistor T6 may be connected to the emission control line ECL. The sixth transistor T6 may be turned on by the emission control signal EM of a gate-on voltage (e.g., a low level voltage at which the sixth transistor T6 can be turned on) supplied from the emission control line ECL to connect the second electrode of the first transistor T1 to the light emitting element LE.

The seventh transistor T7 may be connected between the first electrode of the light emitting element LE (e.g., the anode electrode connected to the sixth transistor T6) and the fourth power line VAIL. The gate electrode of the seventh transistor T7 may be connected to the bias scan line GBL. The seventh transistor T7 may be turned on by the bias scan signal GB of a gate-on voltage (e.g., a low level voltage at which the seventh transistor T7 can be turned on) supplied from the bias scan line GBL to connect the first electrode of the light emitting element LE to the fourth power line VAIL. When the seventh transistor T7 is turned on, the voltage of the first electrode of the light emitting element LE may be initialized to the fourth driving voltage VAINT of the fourth power line VAIL.

The eighth transistor T8 may be connected between the fifth power line VOBL and the first electrode of the first transistor T1. The gate electrode of the eighth transistor T8 may be connected to the bias scan line GBL. The eighth transistor T8 may be turned on by the bias scan signal GB of a gate-on voltage supplied from the bias scan line GBL to connect the first electrode of the first transistor T1 to the fifth power line VOBL. When the eighth transistor T8 is turned on, the voltage of the first electrode of the first transistor T1 may be initialized to the fifth driving voltage VOBS of the fifth power line VOBL. In an embodiment of the present disclosure, the fifth driving voltage VOBS may be a bias voltage having a voltage level suitable for compensating the hysteresis characteristics of the first transistor T1.

The storage capacitor Cst may be connected between the first node N1 and the first power line VDL. The storage capacitor Cst may be charged with a voltage corresponding to the data voltage Vdata applied to the first node N1.

The sub-pixel SPX may emit light during a partial period of each frame period, which corresponds to the on-duty ratio, and might not emit light during the remaining period. The emission period and non-emission period of the sub-pixel SPX may be controlled by the emission control signal EM.

A period during which the fifth transistor T5 and the sixth transistor T6 are turned off (e.g., a period during which the emission control signal EM of a high level is supplied to the sub-pixel SPX) may be a non-emission period of the sub-pixel SPX. The non-emission period of the sub-pixel SPX may include an initialization period for initializing a voltage of a specific node (e.g., the first node N1 or the like) of the sub-pixel SPX, and a data write and storage period for charging the storage capacitor Cst with a voltage corresponding to the data voltage Vdata. In an embodiment of the present disclosure, the initialization scan signal GI, the control scan signal GC, the write scan signal GW, and the bias scan signal GB of a gate-on voltage may be supplied during the non-emission period of the sub-pixel SPX. In an embodiment of the present disclosure, the initialization scan signal GI, the control scan signal GC, and the bias scan signal GB of the gate-on voltage may be sequentially supplied during the non-emission period of the sub-pixel SPX. The periods in which the initialization scan signal GI and the control scan signal GC of the gate-on voltage are supplied may overlap, but the present disclosure is not necessarily limited thereto. The write scan signal GW of the gate-on voltage may be supplied during the period when the control scan signal GC of the gate-on voltage is supplied.

The period during which the fifth transistor T5 and the sixth transistor T6 are turned on (e.g., the period during which the emission control signal EM of a low level is supplied to the sub-pixel SPX) may be an emission period of the sub-pixel SPX. During the emission period of the sub-pixel SPX, the first transistor T1 may supply the driving current Ids corresponding to the voltage of the first node N1 to the light emitting element LE.

The light emitting element LE may be connected between the pixel circuit PXC and the second power line VSL. For example, the first electrode (e.g., the anode electrode or pixel electrode) of the light emitting element LE may be connected to a node between the sixth transistor T6 and the seventh transistor T7, and the second electrode (e.g., the cathode electrode or common electrode) of the light emitting element LE may be connected to the second power line VSL. The light emitting element LE may emit light to correspond to the driving current Ids supplied from the pixel circuit PXC.

In an embodiment of the present disclosure, the light emitting element LE may be an organic light emitting diode (OLED) including an organic light emitting layer, but is not necessarily limited thereto. For example, the light emitting element LE may be another type of light emitting element, such as a quantum dot light emitting diode (quantum dot LED) including a quantum dot light emitting layer, an inorganic light emitting diode (inorganic LED) including an inorganic semiconductor, a micro light emitting diode (micro LED), or a nano light emitting diode (nano LED).

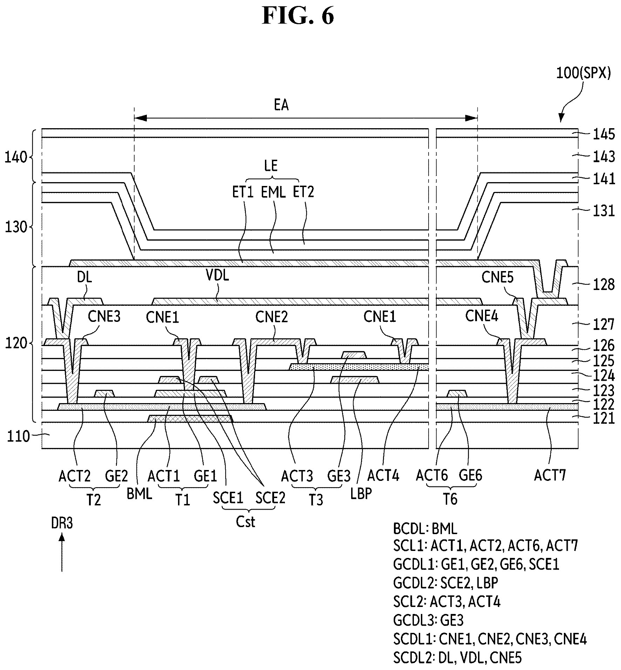

FIG. 6 is a cross-sectional view illustrating a display panel according to an embodiment of the present disclosure. For example, FIG. 6 schematically shows a cross-section of a portion of the display area DA including a portion of a single sub-pixel SPX.

Referring to FIG. 6 in addition to FIGS. 1 to 5, the display panel 100 may include the substrate 110, and the backplane layer 120, the light emitting element layer 130, and the encapsulation layer 140 disposed on the substrate 110. In an embodiment of the present disclosure, the display panel 100 may include at least one of the touch sensing layer 150 or the optical layer 160 of FIG. 3.

The substrate 110 may be a base substrate or base member for forming the display panel 100, and may include a single layer or multiple layers. In an embodiment of the present disclosure, the substrate 110 may include a flexible material such as polymer resin and may be a flexible substrate capable of transformation such as bending, folding, or rolling to at least a noticeable extent without sustaining damage. However, the embodiments are not necessarily limited thereto. In one example, the substrate 110 may be a rigid substrate containing a hard material such as glass.

The substrate 110 may include the display area DA and the non-display area NDA. The display area DA may include the pixel regions PXA where the pixels PX are arranged. Each of the pixel regions PXA may include the emission areas EA and the pixel circuit areas of the sub-pixels SPX.

The backplane layer 120 may include circuit elements included in the pixel circuits PXC of the sub-pixels SPX and wires connected to the sub-pixels SPX. For example, the backplane layer 120 may include the pixel transistors PXT, the storage capacitor Cst, the scan lines SL, the emission control lines ECL, the data lines DL, and the power lines PL of FIG. 5. FIG. 6 shows, as an example of elements that may be included in the backplane layer 120, the first transistor T1, the second transistor T2, the third transistor T3, the sixth transistor T6, and the storage capacitor Cst that are included in one pixel circuit PXC, and the first power line VDL and the data line DL electrically connected to the pixel circuit PXC.

The backplane layer 120 may include at least one semiconductor layer, a plurality of conductive layers, or insulating layers. In an embodiment of the present disclosure, when the pixel circuits PXC include at least two types of pixel transistors PXT containing different materials, the backplane layer 120 may include a plurality of semiconductor layers.

For example, the backplane layer 120 may include a first insulating layer 121, a first semiconductor layer SCL1 (for example, a polycrystalline silicon semiconductor layer), a second insulating layer 122, a first gate conductive layer GCDL1 (or a first conductive layer), a third insulating layer 123, a second gate conductive layer GCDL2 (or a second conductive layer), a fourth insulating layer 124, a second semiconductor layer SCL2 (for example, an oxide semiconductor layer), a fifth insulating layer 125, a third gate conductive layer GCDL3 (or a third conductive layer), a sixth insulating layer 126, a first source-drain conductive layer SCDL1 (or a fourth conductive layer), a seventh insulating layer 127, a second source-drain conductive layer SCDL2 (or a fifth conductive layer), and an eighth insulating layer 128, which are sequentially disposed on the substrate 110 along the third direction DR3. In an embodiment of the present disclosure, the backplane layer 120 may further include a lower conductive layer BCDL disposed between the substrate 110 and the first insulating layer 121.

The lower conductive layer BCDL may include a lower pattern BML disposed below the first transistor T1. The lower pattern BML may entirely or partially cover the bottom surface of a first active layer ACT1 included in the first transistor T1. For example, the lower pattern BML may be disposed below the first active layer ACT1 to overlap a channel region (e.g., a portion of the first active layer ACT1 overlapping the first gate electrode GE1) of the first active layer ACT1.

In an embodiment of the present disclosure, the lower conductive layer BCDL may include a light blocking material. For example, the lower conductive layer BCDL may include metal, and the lower pattern BML may be formed as a lower metal pattern. In an embodiment of the present disclosure, the lower pattern BML may be electrically connected to a power line (e.g., the first power line VDL) to which a constant voltage is applied.

External light may be blocked from entering the channel region or the like of the first active layer ACT1 from the lower portion of the first transistor T1 by the lower pattern BML. Additionally, the charges accumulated around the first transistor T1 may be dispersed by the lower pattern BML. Accordingly, the operating characteristics of the first transistor T1 may be stabilized.

The first insulating layer 121 may be disposed on the lower conductive layer BCDL. The first insulating layer 121 may contain a material (e.g., silicon nitride (SiNₓ), silicon oxide (SiOₓ), silicon oxynitride (SiON), titanium oxide (TiOₓ), aluminum oxide (AlOₓ), or other inorganic insulating materials) suitable for protecting the circuit elements of the backplane layer 120 and the light emitting elements LE on the backplane layer 120 from moisture permeating through the substrate 110 that is susceptible to moisture permeation. The first insulating layer 121 may be formed as a single layer or multiple layers.

The first semiconductor layer SCL1 may be disposed on the first insulating layer 121. The first semiconductor layer SCL1 may include an active layer of each of the pixel transistors PXT of a first type. For example, the first semiconductor layer SCL1 may include the first active layer ACT1 included in the first transistor T1, a second active layer ACT2 included in the second transistor T2, a sixth active layer ACT6 included in the sixth transistor T6, and a seventh active layer ACT7 included in the seventh transistor T7. The first semiconductor layer SCL1 may further include a fifth active layer and an eighth active layer included in the fifth transistor T5 and the eighth transistor T8 of FIG. 5, respectively. For example, the active layers included in the first, second, fifth, sixth, seventh, and eighth transistors T1, T2, T5, T6, T7, and T8 of each pixel circuit PXC may be integrally formed using the same semiconductor material.

The patterns (for example, the active layers included in the first, second, fifth, sixth, seventh and eighth transistors T1, T2, T5, T6, T7, and T8) of the first semiconductor layer SCL1 may include a first semiconductor material. In an embodiment of the present disclosure, the first semiconductor material may be polycrystalline silicon (e.g., low temperature polycrystalline silicon), but is not necessarily limited thereto. For example, the first semiconductor material may be an oxide semiconductor (e.g., at least one of zinc oxide (ZnO), zinc-tin oxide (ZTO), indium-zinc oxide (IZO), indium oxide (InO), titanium oxide (TiO), indium-gallium oxide (IGO), indium-gallium-zinc oxide (IGZO), indium-gallium-tin oxide (IGTO), indium-zinc-tin oxide (IZTO), or indium-tin-gallium-zinc oxide (ITGZO), or another oxide semiconductor) or single crystal silicon.

The second insulating layer 122 may be disposed on the first semiconductor layer SCL1. The second insulating layer 122 may contain at least one insulating material (e.g., an inorganic insulating material) and may be formed as a single layer or multiple layers.

The first gate conductive layer GCDL1 may be disposed on the second insulating layer 122. The first gate conductive layer GCDL1 may include a gate electrode of each of the first type pixel transistors PXT. For example, the first gate conductive layer GCDL1 may include a first gate electrode GE1, a second gate electrode GE2, and a sixth gate electrode GE6 included in the first transistor T1, the second transistor T2, and the sixth transistor T6, respectively. In an embodiment of the present disclosure, the first gate electrode GE1 may be formed integrally with a first capacitor electrode SCE1 among the capacitor electrodes forming the storage capacitor Cst. The first gate conductive layer GCDL1 may further include a fifth gate electrode, a seventh gate electrode, and an eighth gate electrode included in the fifth transistor T5, the seventh transistor T7, and the eighth transistor T8 of FIG. 5, respectively. The patterns (for example, the gate electrodes included in the first, second, fifth, sixth, seventh, and eighth transistors T1, T2, T5, T6, T7, and T8 and the first capacitor electrode SCE 1) of the first gate conductive layer GCDL1 may include the same conductive material. For example, the patterns of the first gate conductive layer GCDL1 may be simultaneously formed using the same conductive material.

The third insulating layer 123 may be disposed on the first gate conductive layer GCDL1. The third insulating layer 123 may contain at least one insulating material (e.g., an inorganic insulating material) and may be formed as a single layer or multiple layers.

The second gate conductive layer GCDL2 may be disposed on the third insulating layer 123. The second gate conductive layer GCDL2 may include the second capacitor electrode SCE2 included in the storage capacitor Cst. The first capacitor electrode SCE1 and the second capacitor electrode SCE2 may overlap each other while the third insulating layer 123 interposed between the first capacitor electrode SCE1 and the second capacitor electrode SCE2. The second capacitor electrode SCE2 may include an opening at a portion where the first capacitor electrode SCE1 is connected to the first connection electrode CNE1. The second capacitor electrode SCE2, which is illustrated as two divided patterns in FIG. 6, may be one pattern that is connected in a plan view. In an embodiment of the present disclosure, the second gate conductive layer GCDL2 may further include a light blocking pattern LBP disposed under a third active layer ACT3 (for example, under the channel region of the third active layer ACT3). The light blocking pattern LBP may also be disposed under a fourth active layer ACT4 (for example, under the channel region of the fourth active layer ACT4). The patterns (for example, the second capacitor electrode SCE2 and the light blocking pattern LBP) of the second gate conductive layer GCDL2 may include the same conductive material.

The fourth insulating layer 124 may be disposed on the second gate conductive layer GCDL2. The fourth insulating layer 124 may contain at least one insulating material (e.g., an inorganic insulating material) and may be formed as a single layer or multiple layers.

The second semiconductor layer SCL2 may be disposed on the fourth insulating layer 124. The second semiconductor layer SCL2 may include an active layer of each of pixel transistors PXT of a second type. For example, the second semiconductor layer SCL2 may include the third active layer ACT3 and the fourth active layer ACT4 included in the third transistor T3 and the fourth transistor T4, respectively. In an embodiment of the present disclosure, the third and fourth active layers ACT3 and ACT4 of each of the pixel circuits PXC may be integrally formed using the same semiconductor material. In FIG. 6, only one end of the fourth active layer ACT4 connected to the third active layer ACT3 is illustrated, and another portion of the fourth active layer ACT4 is inferred.

The patterns (e.g., the third and fourth active layers ACT3 and ACT4) of the second semiconductor layer SCL2 may include a second semiconductor material. In an embodiment of the present disclosure, the second semiconductor material may be an oxide semiconductor, but is not necessarily limited thereto. For example, the second semiconductor material may be polycrystalline silicon or single crystal silicon.

The fifth insulating layer 125 may be disposed on the second semiconductor layer SCL2. The fifth insulating layer 125 may contain at least one insulating material (e.g., an inorganic insulating material) and may be formed as a single layer or multiple layers.

The third gate conductive layer GCDL3 may be disposed on the fifth insulating layer 125. The third gate conductive layer GCDL3 may include a gate electrode of each of the second type pixel transistors PXT. For example, the third gate conductive layer GCDL3 may include a third gate electrode GE3 included in the third transistor T3. The third gate conductive layer GCDL3 may further include a fourth gate electrode included in the fourth transistor T4. The patterns (for example, the gate electrodes included in the third and fourth transistors T3 and T4) of the third gate conductive layer GCDL3 may include the same conductive material.

The sixth insulating layer 126 may be disposed on the third gate conductive layer GCDL3. The sixth insulating layer 126 may contain at least one insulating material (e.g., an inorganic insulating material) and may be formed as a single layer or multiple layers.

The first source-drain conductive layer SCDL1 may be disposed on the sixth insulating layer 126. The first source-drain conductive layer SCDL1 may include at least one electrode, a conductive pattern and/or a wire. For example, the first source-drain conductive layer SCDL1 may include first, second, third, and fourth connection electrodes CNE1, CNE2, CNE3, and CNE4. The patterns (for example, the first, second, third, and fourth connection electrodes CNE1, CNE2, CNE3, and CNE4) of the first source-drain conductive layer SCDL1 may include the same conductive material.

The first connection electrode CNE1 may be a conductive pattern for forming the first node N1 of FIG. 5. For example, the first connection electrode CNE1 may connect the first gate electrode GE1 and the first capacitor electrode SCE1 to the third and fourth active layers ACT3 and ACT4. For example, a part of the first connection electrode CNE1 may penetrate the insulating layers disposed between the first gate conductive layer GCDL1 and the first source-drain conductive layer SCDL1 (for example, through the contact hole formed in the insulating layers disposed between the first gate conductive layer GCDL1 and the first source-drain conductive layer SCDL1) to be connected to the first gate electrode GE1 and the first capacitor electrode SCE1, and another part of the first connection electrode CNE1 may be connected to the third and fourth active layers ACT3 and ACT4 through the insulating layers disposed between the second semiconductor layer SCL2 and the first source-drain conductive layer SCDL1. The first connection electrode CNE1 illustrated as two divided patterns in FIG. 6 may be one pattern that is connected in a plan view.

The second connection electrode CNE2 may connect the first transistor T1 to the third transistor T3. For example, a part of the second connection electrode CNE2 may penetrate the insulating layers disposed between the first semiconductor layer SCL1 and the first source-drain conductive layer SCDL1 to be connected to a part (for example, a drain region) of the first active layer ACT1, and another part of the second connection electrode CNE2 may penetrate the insulating layers disposed between the second semiconductor layer SCL2 and the first source-drain conductive layer SCDL1 to be connected to a part (for example, a drain region) of the third active layer ACT3.

The third connection electrode CNE3 may connect the second transistor T2 to the data line DL. For example, the third connection electrode CNE3 may penetrate the insulating layers disposed between the first semiconductor layer SCL1 and the first source-drain conductive layer SCDL1 to be connected to a part (e.g., a source region) of the second active layer ACT2, and the data line DL may penetrate the insulating layer (e.g., the seventh insulating layer 127) disposed between the first source-drain conductive layer SCDL1 and the second source-drain conductive layer SCDL2 to be connected to the third connection electrode CNE3.

The fourth connection electrode CNE4 may connect the sixth and seventh transistors T6 and T7 to the fifth connection electrode CNE5. For example, the fourth connection electrode CNE4 may penetrate the insulating layers disposed between the first semiconductor layer SCL1 and the first source-drain conductive layer SCDL1 to be connected to a part of the sixth and seventh active layers ACT6 and ACT7 (for example, the source or drain region of each of the sixth and seventh active layers ACT6 and ACT7), and the fifth connection electrode CNE5 may penetrate the insulating layer (for example, the seventh insulating layer 127) disposed between the first source-drain conductive layer SCDL1 and the second source-drain conductive layer SCDL2 to be connected to the fourth connection electrode CNE4. In FIG. 6, only a part of the seventh active layer ACT7 connected to the sixth active layer ACT6 is illustrated, and another part of the seventh active layer ACT7 is inferred.

The seventh insulating layer 127 may be disposed on the first source-drain conductive layer SCDL1. The seventh insulating layer 127 may include at least one insulating material (e.g., acrylic resin, epoxy resin, phenolic resin, polyamide resin, polyimide resin, or another organic insulating material) and may be formed as a single layer or multiple layers.

The second source-drain conductive layer SCDL2 may be disposed on the seventh insulating layer 127. The second source-drain conductive layer SCDL2 may include at least one electrode, a conductive pattern and/or a wire. For example, the second source-drain conductive layer SCDL2 may include the data line DL, the first power line VDL, and the fifth connection electrode CNE5. The patterns (for example, the data line DL, the first power line VDL, and the fifth connection electrode CNE5) of the second source-drain conductive layer SCDL2 may include the same conductive material.

The data line DL may penetrate the seventh insulating layer 127 to be connected to the third connection electrode CNE3. The data line DL may be connected to the second transistor T2 through the third connection electrode CNE3.

The first power line VDL may be connected to the second capacitor electrode SCE2 and the fifth transistor T5 in an area that is inferred. The first power line VDL may overlap the first transistor T1. Accordingly, light incident from the upper portion of the first transistor T1 on the channel region of the first active layer ACT1 may be blocked or reduced, and the operating characteristics of the first transistor T1 may be stabilized. In an embodiment of the present disclosure, the first power line VDL may further overlap the third and fourth transistors T3 and T4. Accordingly, light incident from the upper portion of the third and fourth transistors T3 and T4 on the channel regions of the third and fourth active layers ACT3 and ACT4 may be blocked or reduced, and the operating characteristics of the third and fourth transistors T3 and T4 may be stabilized.

The fifth connection electrode CNE5 may connect the fourth connection electrode CNE4 to a first electrode ET1 of the light emitting element LE. For example, the fifth connection electrode CNE5 may penetrate the seventh insulating layer 127 to be connected to the fourth connection electrode CNE4, and the first electrode ET1 of the light emitting element LE may penetrate the eighth insulating layer 128 to be connected to the fifth connection electrode CNE5.

The eighth insulating layer 128 may be disposed on the second source-drain conductive layer SCDL2. The eighth insulating layer 128 may contain at least one insulating material (e.g., an organic insulating material) and may be formed as a single layer or multiple layers.

The patterns included in each of the conductive layers of the backplane layer 120 may contain at least one conductive material. For example, the electrodes, the conductive patterns, and/or the wires included in each of the first gate conductive layer GCDL1, the second gate conductive layer GCDL2, the third gate conductive layer GCDL3, the first source-drain conductive layer SCDL1 and the second source-drain conductive layer SCDL2 may include at least one of copper (Cu), titanium (Ti), molybdenum (Mo), aluminum (Al), chromium (Cr), gold (Au), silver (Ag), platinum (Pt), palladium (Pd), nickel (Ni), neodymium (Nd), iridium (Ir), tantalum (Ta), tungsten (W), magnesium (Mg), or another metal, an alloy thereof, or another conductive material. In an embodiment of the present disclosure, the electrodes, the conductive patterns, and/or the wires disposed in the same conductive layer may be simultaneously formed using the same conductive material. At least two conductive layers of the conductive layers of the backplane layer 120 may include the same conductive material or may include different conductive materials.

In an embodiment of the present disclosure, the patterns included in each of the conductive layers of the backplane layer 120 may have a single-layer or multi-layer structure. For example, each of the electrodes, conductive patterns and/or wires included in each of the first gate conductive layer GCDL1, the second gate conductive layer GCDL2, the third gate conductive layer GCDL3, the first source-drain conductive layer SCDL1, and the second source-drain conductive layer SCDL2 may have a single-layer or multilayer structure. At least two of the conductive layers of the backplane layer 120 may have the same cross-sectional structure or different cross-sectional structures.

In an embodiment of the present disclosure, each of the conductive layers of the backplane layer 120 may further include at least one wire and/or conductive pattern. For example, the scan lines SL, the emission control line ECL, and the power lines PL of FIG. 5 may each be formed as a single or multilayer wiring layer included in at least one conductive layer included in the backplane layer 120. In an embodiment of the present disclosure, the scan lines SL, the emission control line ECL, and the power lines PL may each be formed integrally with a part of at least one circuit element included in the pixel circuit PXC, or may be electrically connected to at least one circuit element included in the pixel circuit PXC through at least one contact hole and/or connection pattern.

The light emitting element layer 130 may be disposed on the eighth insulating layer 128. The light emitting element layer 130 may be disposed in the display area DA. For example, the light emitting element layer 130 may be disposed on the backplane layer 120 in the display area DA.

The light emitting element layer 130 may include the light emitting elements LE of the sub-pixels SPX. For example, the light emitting element layer 130 may include a pixel defining film 131 that partitions the emission areas EA of the sub-pixels SPX, and the light emitting element LE disposed in each emission area EA. In an embodiment of the present disclosure, the light emitting element layer 130 may further include a spacer disposed on a portion of the pixel defining film 131.

The light emitting element LE may include the first electrode ET1 (e.g., anode electrode) and a second electrode ET2 (e.g., cathode electrode) opposing each other, and a light emitting layer EML disposed between the first electrode ET1 and the second electrode ET2. In an embodiment of the present disclosure, the first electrode ET1, the light emitting layer EML, and the second electrode ET2 may be sequentially stacked on the backplane layer 120 along the third direction DR3.

In an embodiment of the present disclosure, the light emitting element LE may further include at least one intermediate layer. For example, the light emitting element LE may further include a first intermediate layer (e.g., a hole layer including a hole transport layer) interposed between the first electrode ET1 and the light emitting layer EML, and a second intermediate layer (e.g., an electron layer including an electron transport layer) interposed between the light emitting layer EML and the second electrode ET2. In an embodiment of the present disclosure, at least one intermediate layer may be a common film formed across the entire display area DA.

Although FIG. 6 illustrates an embodiment in which the light emitting element LE includes a single light emitting layer EML, the embodiments are not necessarily limited thereto. For example, the light emitting element LE may be formed in a structure of two or more tandems including at least two light emitting layers (e.g., the light emitting layer EML of FIG. 3, and an additional light emitting layer overlapping the light emitting layer EML) that overlap each other in the third direction DR3. The light emitting element LE may further include a charge generation layer interposed between the at least two light emitting layers. The light emitting layer EML may be provided in the form of a common film formed across the entire display area DA, or may be disposed in each emission area EA with a shape and/or size corresponding to each emission area EA.

In an embodiment of the present disclosure, each of the sub-pixels SPX may include the light emitting element LE that emits light of a color corresponding to the emission color (or emission wavelength) of the corresponding sub-pixel SPX. For example, the first sub-pixel SPX1 may include the light emitting element LE of the first color (e.g., a red light emitting element) that emits light of the first color, the second sub-pixel SPX2 may include the light emitting element LE of the second color (e.g., a green light emitting element) that emits light of the second color, and the third sub-pixel SPX3 may include the light emitting element LE of the third color (e.g., a blue light emitting element) that emits light of the third color.

In an embodiment, at least one sub-pixel SPX may include the light emitting element LE that emits light of a different color from the emission color (or emission wavelength) of the corresponding sub-pixel SPX. In this case, the display panel 100 may further include a wavelength conversion layer (e.g., a wavelength conversion layer including a quantum dot of a size corresponding to the emission wavelength of the corresponding sub-pixel SPX) disposed on the light emitting element LE and converting the color (or wavelength) of light emitted from the light emitting element LE.

The first electrode ET1 of the light emitting element LE may be disposed on the backplane layer 120. For example, the first electrode ET1 of the light emitting element LE may be disposed on the eighth insulating layer 128 corresponding to each emission area EA. The first electrode ET1 of the light emitting element LE may be electrically connected to the pixel circuit PXC of the corresponding sub-pixel SPX through at least one connection electrode. For example, the first electrode ET1 of the light emitting element LE may penetrate the eighth insulating layer 128 to be connected to the fifth connection electrode CNES, and may be connected to the sixth and seventh transistors T6 and T7 through the fifth connection electrode CNES and the fourth connection electrode CNE4 connected to the fifth connection electrode CNES.

The first electrode ET1 of the light emitting element LE may include at least one conductive material and may be formed as a single layer or multiple layers. In an embodiment of the present disclosure, the first electrode ET1 of the light emitting element LE may include a reflective electrode layer containing a highly reflective metallic material. Accordingly, the light efficiency of the sub-pixel SPX may be increased.

The light emitting layer EML of the light emitting element LE may include a high molecular material or a low molecular material. Light emitted from the light emitting layer EML may contribute to image display. In an embodiment of the present disclosure, the light emitting layer EML may be provided or formed for each sub-pixel SPX, and the light emitting layer EML of each sub-pixel SPX may emit visible light of a color or wavelength corresponding to the corresponding sub-pixel SPX. In an embodiment, the light emitting layer EML may be a common layer shared by the sub-pixels SPX of different colors, and a light conversion layer and/or color filters corresponding to the color (or wavelength) of light desired to be emitted from each sub-pixel SPX may be arranged in the emission areas EA of at least some of the sub-pixels SPX.

The second electrode ET2 of the light emitting element LE may include a conductive material. In an embodiment of the present disclosure, the second electrode ET2 of the light emitting element LE may be a common layer formed across the entire display area DA to cover the light emitting layer EML and the pixel defining film 131. In an embodiment of the present disclosure, the second electrode ET2 of the light emitting element LE may include transparent conductive oxide (TCO) such as ITO or IZO capable of transmitting light or a semi-transmissive conductive material such as magnesium (Mg), silver (Ag), or an alloy of magnesium (Mg) and silver (Ag).

The pixel defining film 131 may have an opening corresponding to each of the emission areas EA and may surround the emission areas EA. For example, the pixel defining film 131 may cover an edge of the first electrode ET1 of the light emitting element LE and may include an opening exposing another portion of the first electrode ET1. A region where the exposed first electrode ET1 and the light emitting layer EML overlap (or a region including the same) may be defined as the emission area EA of each sub-pixel SPX.

In an embodiment of the present disclosure, the pixel defining film 131 may include an organic insulating material. For example, the pixel defining film 131 may include acrylic resin, epoxy resin, phenolic resin, polyamide resin, polyimide resin, unsaturated polyester resin, polyphenylene ether resin, polyphenylenesulfide resin, benzocyclobutene (BCB), or other organic insulating materials.

The encapsulation layer 140 may be disposed on the light emitting element layer 130. The encapsulation layer 140 may cover the light emitting element layer 130 in the display area DA and may extend to the non-display area NDA to be in contact with the backplane layer 120. For example, the encapsulation layer 140 may be disposed in the display area DA to cover the light emitting element layer 130, and the end of the encapsulation layer 140 may be disposed in a portion of the non-display area NDA adjacent to the display area DA. The encapsulation layer 140 may block the permeation of oxygen or moisture into the light emitting element layer 130, and may mitigate electrical and/or physical impacts to the backplane layer 120 and the light emitting element layer 130.

In an embodiment of the present disclosure, the encapsulation layer 140 may be formed as multiple layers including an inorganic encapsulation layer and an organic encapsulation layer. For example, the encapsulation layer 140 may include a first inorganic encapsulation layer 141, an organic encapsulation layer 143, and a second inorganic encapsulation layer 145 sequentially arranged on the light emitting element layer 130. The encapsulation layer 140 may be replaced by an encapsulation member of a different type, structure and/or material. For example, the light emitting element layer 130 may be encapsulated using an upper substrate including an insulating material such as glass, or a protective layer including a single or multilayer capping layer.

Thus, a flexible light-emitting display device, such as one using OLED technology, that includes a complex layered structure may enable high image quality and durability. The device may include of a display panel with a main region and a sub-region, where the sub-region can be bent or folded, allowing for compact or foldable electronic designs. The display panel may include a matrix of pixels, each comprising multiple sub-pixels emitting red, green, and blue light via organic or inorganic light-emitting elements. Each sub-pixel may include its own dedicated circuit with multiple transistors and a storage capacitor, which precisely control light emission in response to scan, data, and power signals. The device may integrate touch sensing capabilities and an optical layer to enhance display performance. The layered structure may include semiconductors, conductive and insulating materials arranged to optimize electrical performance and protect against moisture and light interference, contributing to stable operation and high display efficiency.

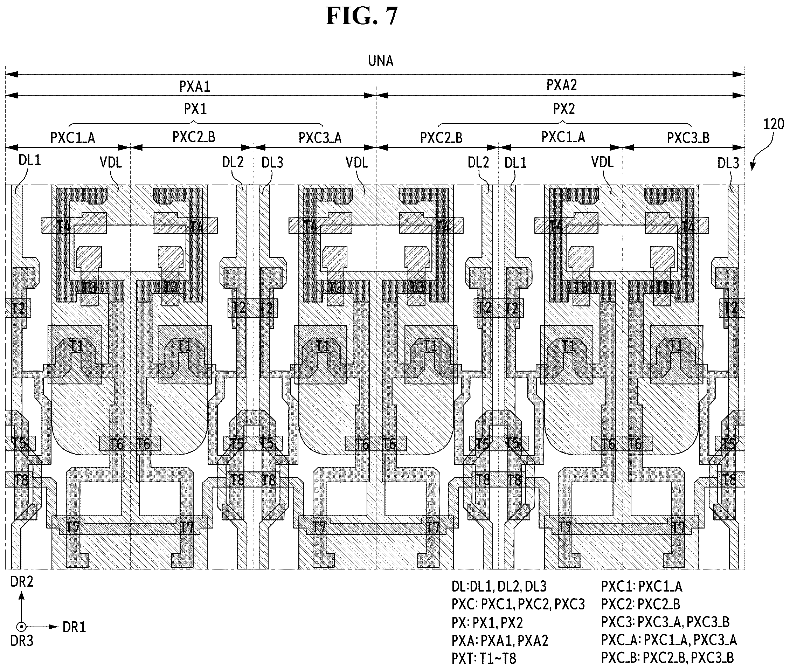

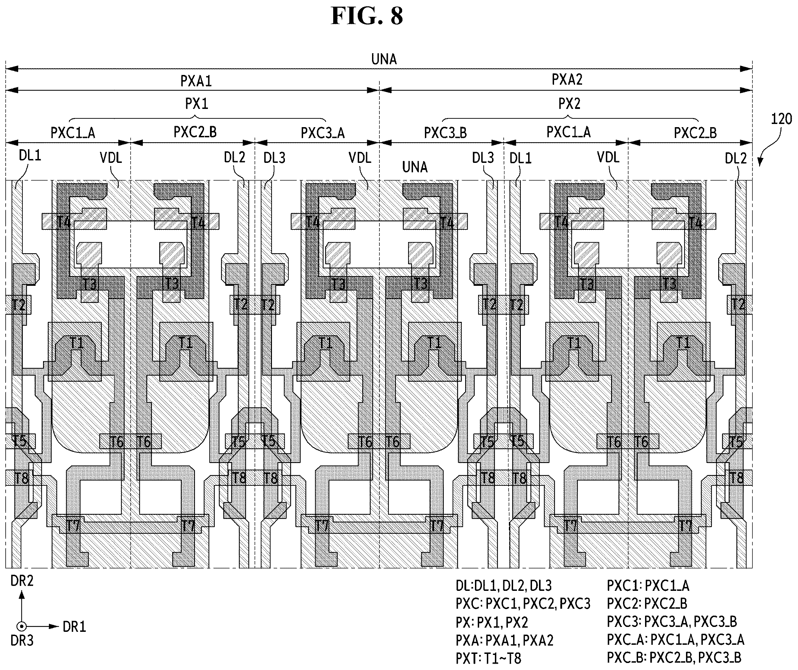

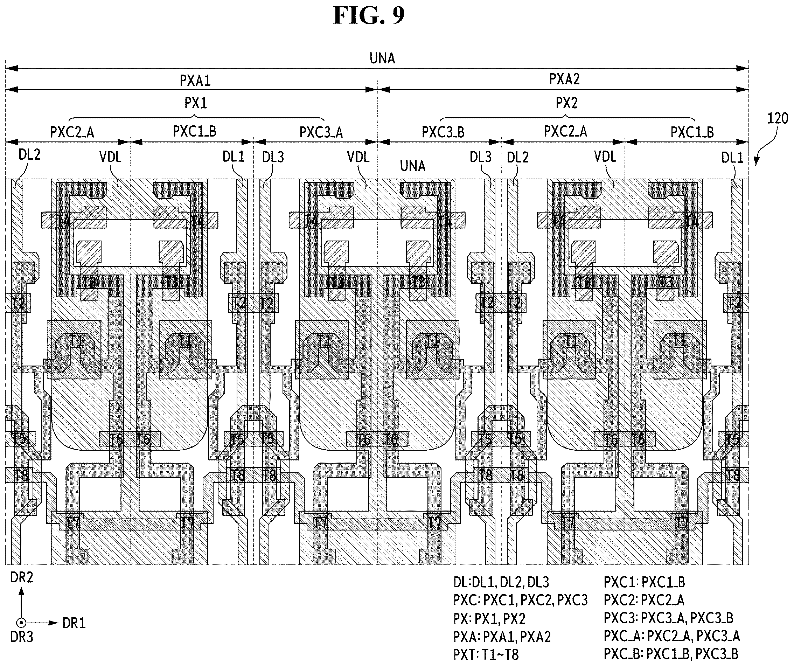

FIG. 7 is a plan view showing a backplane layer of a display panel according to an embodiment of the present disclosure. FIG. 8 is a plan view showing a backplane layer of a display panel according to an embodiment of the present disclosure. FIG. 9 is a plan view showing a backplane layer of a display panel according to an embodiment of the present disclosure.

For example, each of FIGS. 7, 8 and 9 shows a part of the display area DA corresponding to the unit structure UNA where a pair of the first pixel PX1 and the second pixel PX2 are disposed, and shows an embodiment of the present disclosure of the pixel circuits PXC, the data lines DL, and the first power line VDL that are disposed inside the backplane layer 120 of the display panel 100 in the unit structure UNA. FIGS. 7, 8 and 9 show different embodiments related to the type, arrangement shape and/or order of the pixel circuits PXC disposed in each unit structure UNA. In addition, FIGS. 7, 8 and 9 show the pixel transistors PXT included in each of the pixel circuits PXC in order to show the structure of the pixel circuits PXC according to the respective embodiments.

Referring to FIGS. 7 to 9 in addition to FIGS. 1 to 6, the backplane layer 120 of the display panel 100 may include the pixel circuits PXC disposed in each unit structure UNA, and the first power line VDL and the data lines DL electrically connected to the pixel circuits PXC. In the display area DA, the first power line VDL may have a shape in which it is branched into a plurality of lines. Accordingly, hereinafter, the first power line VDL is also referred to as a plurality of first power lines VDL.

In the display area DA, a plurality of unit structures UNA may be arranged along the first direction DR1 and the second direction DR2. The unit structures UNA may have substantially the same shape or structure. For example, the display area DA may have a shape in which the unit structure UNA according to the embodiment of FIG. 7, FIG. 8 or FIG. 9 is repeatedly disposed along the first direction DR1 and the second direction DR2.

In each unit structure UNA, the pixel circuits PXC of the sub-pixels SPX included in a pair of pixels PX adjacent to each other in the first direction DR1 may be disposed. For example, the unit structure UNA may include the first pixel region PXA1 where the first pixel PX1 is disposed and the second pixel region PXA2 where the second pixel PX2 is disposed. In the first pixel region PXA1, the first pixel circuit PXC1, the second pixel circuit PXC2, and the third pixel circuit PXC3 of the first pixel PX1 may be disposed, and in the second pixel region PXA2, the first pixel circuit PXC1, the second pixel circuit PXC2, and the third pixel circuit PXC3 of the second pixel PX2 may be disposed. Accordingly, six pixel circuits PXC may be disposed in the unit structure UNA including the first pixel region PXA1 and the second pixel region PXA2. In addition, the number of pixels PX and/or sub-pixels SPX disposed in each unit structure UNA may vary depending on embodiments. FIGS. 7, 8, and 9 illustrate the embodiment of the backplane layer 120, and each pixel region PXA of FIGS. 7, 8, and 9 may be defined with respect to an area where the pixel circuits PXC of the corresponding pixel PX are disposed.

The pixel circuits PXC of the unit structure UNA may be arranged along one direction. For example, the pixel circuits PXC of the first pixel PX1 and the second pixel PX2 may be arranged in the first direction DR1.

In the embodiments of FIGS. 7, 8, and 9, in the unit structure UNA where a pair of the first pixel PX1 and the second pixel PX2 are disposed and the display area DA including the unit structure UNA, the pixel circuits PXC of different types may be alternately arranged in the first direction DR1. For example, in the unit structure UNA and the display area DA including the unit structure UNA, pixel circuits PXC_A of a first type and pixel circuits PXC_B of a second type may be alternately arranged along the first direction DR1. For example, two pixel circuits PXC among three pixel circuits PXC included in each pixel PX may be the first type pixel circuits PXC_A or the second type pixel circuits PXC_B, and the other one pixel circuit PXC among the pixel circuits PXC included in each pixel PX may be a pixel circuit PXC of a type different from those of the two pixel circuits PXC.

In addition, in the embodiments of FIGS. 7, 8, and 9, the arrangement shape or order of the first pixel circuit PXC1, the second pixel circuit PXC2, and the third pixel circuit PXC3 of the first pixel PX1 may be different from the arrangement shape or order of the first pixel circuit PXC1, the second pixel circuit PXC2, and the third pixel circuit PXC3 of the second pixel PX2. For example, as in the embodiment of FIG. 7, the arrangement order of the first pixel circuit PXC1 and the second pixel circuit PXC2 of the first pixel PX1 and the arrangement order of the first pixel circuit PXC1 and the second pixel circuit PXC2 of the second pixel PX2 may be opposite to each other, and the third pixel circuit PXC3 of the first pixel PX1 may be adjacent to the second pixel circuit PXC2 of the second pixel PX2. Alternatively, as in the embodiments of FIGS. 8 and 9, the arrangement order of the first pixel circuit PXC1 and the second pixel circuit PXC2 of the first pixel PX1 and the arrangement order of the first pixel circuit PXC1 and the second pixel circuit PXC2 of the second pixel PX2 may be the same, and the third pixel circuit PXC3 of the first pixel PX1 may be adjacent to the third pixel circuit PXC3 of the second pixel PX2.

In the embodiment of FIG. 7, the first pixel PX1 may include a first type first pixel circuit PXC1_A, a second type second pixel circuit PXC2_B, and a first type third pixel circuit PXC3_A, which are sequentially arranged along the first direction DR1. The second pixel PX2 may include the second type second pixel circuit PXC2_B, the first type first pixel circuit PXC1_A, and a second type third pixel circuit PXC3_B, which are sequentially arranged along the first direction DR1.

In the embodiment of FIG. 8, the first pixel PX1 may include the first type first pixel circuit PXC1_A, the second type second pixel circuit PXC2_B, and the first type third pixel circuit PXC3_A, which are sequentially arranged along the first direction DR1. The second pixel PX2 may include the second type third pixel circuit PXC3_B, the first type first pixel circuit PXC1_A, and the second type second pixel circuit PXC2_B, which are sequentially arranged along the first direction DR1.

In the embodiment of FIG. 9, the first pixel PX1 may include a first type second pixel circuit PXC2_A, a second type first pixel circuit PXC1_B, and the first type third pixel circuit PXC3_A, which are sequentially arranged along the first direction DR1. The second pixel PX2 may include the second type third pixel circuit PXC3_B, the first type second pixel circuit PXC2_A, and the second type first pixel circuit PXC1_B, which are sequentially arranged along the first direction DR1.

The first type pixel circuits PXC_A and the second type pixel circuits PXC_B may have different shapes. For example, the first type pixel circuits PXC_A and the second type pixel circuits PXC_B may have substantially opposite or symmetrical shapes. For example, a pair of the first type pixel circuit PXC_A and the second type pixel circuit PXC_B adjacent to each other in the first direction DR1 may be designed in a flipped shape. As used herein, the phrase "symmetrically opposite shape" or "opposite shape" is intended to mean a mirror image shape.

For example, the arrangement shape, order, position, and/or direction of the circuit elements included in each of the first type pixel circuits PXC_A may be different from the arrangement shape, order, position, and/or direction of the circuit elements included in each of the second type pixel circuits PXC_B. For example, the first type pixel circuits PXC_A and the second type pixel circuits PXC_B may be substantially opposite or symmetrical in arrangement shape, order, position and/or direction of the first to eighth transistors T1 to T8 included in each pixel circuit PXC.

The pixel circuits PXC of the same type may have substantially the same shape. For example, the arrangement shape order, position and/or direction of the circuit elements included in one first type pixel circuit PXC_A may be substantially the same as the arrangement shape, order, position and/or direction of the circuit elements included in another first type pixel circuit PXC_A. For example, the arrangement shape, order, position, and/or direction of the first to eighth transistors T1 to T8 included in the first type pixel circuit PXC_A may be substantially the same as the arrangement shape, order, position, and/or direction of the first to eighth transistors T1 to T8 included in another first type pixel circuit PXC_A. In addition, the arrangement shape, order, position, and/or direction of the circuit elements included in one second type pixel circuit PXC_B may be substantially the same as the arrangement shape, order, position, and/or direction of the circuit elements included in another second type pixel circuit PXC_B. In an embodiment of the present disclosure, the arrangement shape, order, position, and/or direction of the pixel transistors PXT (for example, the first to eighth transistors T1 to T8) included in the pixel circuit PXC of each sub-pixel SPX may be defined with respect to the shape or position of the semiconductor pattern including the active layers of the pixel transistors PXT.

In describing the embodiments, the case in which the circuit elements included in the two pixel circuits PXC are substantially the same in arrangement shape, order, position, and/or direction may mean that the arrangement positions of the circuit elements (for example, the first transistors T1 of the two pixel circuits PXC) corresponding to each other among the circuit elements included in the two pixel circuits PXC in each pixel circuit PXC, the shapes and/or the arrangement order or direction of the circuit elements are "substantially the same." Here, "substantially the same" includes the meaning of "completely the same," and may also mean that the circuit elements are generally the same or similar in arrangement shape, order, position, and/or direction even if the shape of a part of the pixel circuit PXC becomes partially slightly different depending on the area where the wire connected to the pixel circuit PXC is disposed, or the contact area for connection between the pixel circuit PXC and the light emitting element LE. On the contrary, the case in which the circuit elements included in the two pixel circuits PXC are different in arrangement shape, order, position and/or direction may mean that the circuit elements included in the two pixel circuits PXC are substantially not the same in arrangement shape, order, position and/or direction.

In some embodiments, the first pixel circuits PXC1 of the first pixel PX1 and the second pixel PX2 may be the pixel circuits PXC of the same type, and the second pixel circuits PXC2 of the first pixel PX1 and the second pixel PX2 may be the pixel circuits PXC of the same type. In addition, the first pixel circuits PXC1 of the first pixel PX1 and the second pixel PX2 may be the pixel circuits PXC of the type different from those of the second pixel circuits PXC2 of the first pixel PX1 and the second pixel PX2. For example, the first pixel circuits PXC1 of the first pixel PX1 and the second pixel PX2 may be the first type pixel circuits PXC_A, and the second pixel circuits PXC2 of the first pixel PX1 and the second pixel PX2 may be the second type pixel circuits PXC_B. Alternatively, the first pixel circuits PXC1 of the first pixel PX1 and the second pixel PX2 may be the second type pixel circuits PXC_B, and the second pixel circuits PXC2 of the first pixel PX1 and the second pixel PX2 may be the first type pixel circuits PXC_A.

When the first pixel circuits PXC1 have substantially the same shape, even if the overlay is misaligned in the manufacturing process of the display panel 100, the operating characteristics of the first pixel circuits PXC1 may be generally uniform. For example, even if the driving current Ids of the first sub-pixels SPX1 controlled by the first pixel circuits PXC1 changes due to the misalignment of the overlay, the direction in which the driving current Ids changes in the first sub-pixels SPX1 may be substantially the same. For example, when the driving current Ids of the first sub-pixels SPX1 changes due to the misalignment of the overlay, the driving current Ids of the first sub-pixels SPX1 may increase to substantially the same or similar degree, or decrease to substantially the same or similar degree. Accordingly, the operating characteristics of the first sub-pixels SPX1 may be uniform.

In describing the embodiments, "the overlay is misaligned" may mean that an alignment error occurs because the positional alignment between layers is incorrect in the manufacturing process of the display panel 100. When the alignment error occurs between at least two conductive layers included in the backplane layer 120, the size, shape, position, and/or operating characteristics of the circuit elements formed in the backplane layer 120 may change by the patterns included in the at least two conductive layers.

Similarly, when the second pixel circuits PXC2 have substantially the same shape, even if the overlay is misaligned in the manufacturing process of the display panel 100, the operating characteristics of the second pixel circuits PXC2 may be generally uniform. For example, when the driving current Ids of the second sub-pixels SPX2 changes due to the misalignment of the overlay, the driving current Ids of the second sub-pixels SPX2 may increase to substantially the same or similar degree, or decrease to substantially the same or similar degree. Accordingly, the operating characteristics of the second sub-pixels SPX2 may be uniform.

The third pixel circuits PXC3 of the first pixel PX1 and the second pixel PX2 may be the pixel circuits PXC of different types. For example, the third pixel circuit PXC3 of the first pixel PX1 may be the first type pixel circuit PXC3_A, and the third pixel circuit PXC3 of the second pixel PX2 may be the second type pixel circuit PXC3_B. Alternatively, the third pixel circuit PXC3 of the first pixel PX1 may be the second type pixel circuit PXC3_B, and the third pixel circuit PXC3 of the second pixel PX2 may be the first type pixel circuit PXC3_A. Accordingly, the same number of the first type pixel circuits PXC_A and the second type pixel circuits PXC_B may be disposed in each unit structure UNA.

In some embodiments, the third sub-pixels SPX3 including the respective third pixel circuits PXC3 may be the sub-pixels SPX that are relatively insensitive to the change in the driving current Ids. For example, among the first sub-pixel SPX1, the second sub-pixel SPX2, and the third sub-pixel SPX3 of each pixel PX, the third sub-pixel SPX3 may be the sub-pixel SPX having the smallest amount of change in luminance according to the change in the driving current Ids. Accordingly, even if the overlay is misaligned in the manufacturing process of the display panel 100, the variation in the operating characteristics of the third pixel circuits PXC3 may be relatively small. For example, even if the driving current Ids flowing to the respective third sub-pixels SPX3 by the first type third pixel circuits PXC3_A and the second type third pixel circuits PXC3_B changes in different directions due to the misalignment of the overlay, the variation in the driving current Ids of the third sub-pixels SPX3 including the first type third pixel circuits PXC3_A and the driving current Ids of the third sub-pixels SPX3 including the second type third pixel circuits PXC3_B may be slight. For example, the variation (for example, the difference in luminance and/or color) in the emission characteristics of the pixels PX (for example, the first pixel PX1) including the first type third pixel circuits PXC3_A and the pixels PX (for example, the second pixel PX2) including the second type third pixel circuits PXC3_B might not substantially occur (for example, the luminance variation and/or color difference that is difficult to be perceived with human eyes may occur), or may be so small so as not to significantly affect the image quality.

In some embodiments, a pair of the first type pixel circuit PXC_A and the second type pixel circuits PXC_B adjacent to each other in the first direction DR1 may share one first power line VDL. The one first power line VDL may be disposed between the pair of the first type pixel circuit PXC_A and the second type pixel circuit PXC_B, or may overlap the pair of the first type pixel circuit PXC_A and the second type pixel circuit PXC_B. For example, each of the first power lines VDL may overlap the pair of the first type pixel circuit PXC_A and the second type pixel circuit PXC_B, and may be commonly connected to the pair of the first type pixel circuit PXC_A and the second type pixel circuit PXC_B. In addition, a pair of the first type pixel circuit PXC_A and the second type pixel circuit PXC_B may have opposite or symmetrical shapes with respect to one first power line VDL shared by them and/or the boundary line (for example, a dotted line between a pair of the first type pixel circuit PXC_A and the second type pixel circuit PXC_B in FIG. 7, FIG. 8 or FIG. 9) between the pair of the first type pixel circuit PXC_A and the second type pixel circuit PXC_B. The data lines DL connected to a pair of the first type pixel circuit PXC_A and the second type pixel circuit PXC_B may be disposed at positions facing each other while the first power line VDL, which overlaps the pair of the first type pixel circuit PXC_A and the second type pixel circuit PXC_B, is interposed between the data lines DL. For example, the data line DL connected to the first type pixel circuit PXC_A may be disposed on the left side of the first power line VDL, and the data line DL connected to the second type pixel circuit PXC_B may be disposed on the right side of the first power line VDL. For example, in the embodiment of FIG. 7, a first data line DL1 connected to the first pixel circuit PXC1 of the first pixel PX1 and a second data line DL2 connected to the second pixel circuit PXC2 of the first pixel PX1 may face each other with one first power line VDL interposed between the first data line DL1 and the second data line DL2. In addition, two data lines DL connected to two sub-pixels SPX adjacent to each other in the first direction DR1 may be disposed adjacent to each other. For example, in the embodiment of FIG. 7, the second data line DL2 connected to the second pixel circuit PXC2 of the first pixel PX1 and a third data line DL3 connected to the third pixel circuit PXC3 of the first pixel PX1 may be adjacent to each other in the first direction DR1. According to the embodiments, since the pixel circuits PXC adjacent to each other in the first direction DR1 share the first power line VDL, the pixel circuits PXC and the first power line VDL may be efficiently disposed in the display area DA, and the design structure of the backplane layer 120 may be improved or optimized. In addition, since the width of each first power line VDL may be expanded, the first driving voltage VDD may be supplied more smoothly to the sub-pixels SPX.

The data lines DL and the first power lines VDL may extend in the same direction in the display area DA. For example, the data lines DL and the first power lines VDL may be arranged in the first direction DR1 in the display area DA, and the data lines DL and the first power lines VDL may each extend in the second direction DR2.

In each pixel column of the display area DA including the plurality of pixels PX arranged along the second direction DR2, the first data line DL1 connected to the first pixel circuits PXC1 of the corresponding pixel column, the second data line DL2 connected to the second pixel circuits PXC2 of the corresponding pixel column, and the third data line DL3 connected to the third pixel circuits PXC3 of the corresponding pixel column may be disposed.

In a pair of pixel columns adjacent to each other in the first direction DR1, the first power lines VDL whose number is approximately half of the number of the pixel circuits PXC disposed in each unit structure UNA may be disposed. For example, when six pixel circuits PXC are disposed in one unit structure UNA, three first power lines VDL may be disposed in two pixel columns (for example, a first pixel column including the first pixel PX1 and a second pixel column including the second pixel PX2) including the unit structure UNA.

In an embodiment of the present disclosure, the pixel circuits PXC of the pixels PX arranged in the same pixel column may be arranged in the same shape and/or order. For example, the first pixel circuits PXC1 of the first pixel column including the plurality of pixels PX arranged in the second direction DR2 in the display area DA and including the first pixel PX1 may be arranged sequentially and/or continuously along the second direction DR2. In addition, the second pixel circuits PXC2 of the first pixel column may be arranged sequentially and/or continuously along the second direction DR2, and the third pixel circuits PXC3 of the first pixel column may be arranged sequentially and/or continuously along the second direction DR2. Similarly, the first pixel circuits PXC1 of the second pixel column including the plurality of pixels PX arranged in the second direction DR2 in the display area DA and including the second pixel PX2 may be arranged sequentially and/or continuously along the second direction DR2. In addition, the second pixel circuits PXC2 of the second pixel column may be arranged sequentially and/or continuously along the second direction DR2, and the third pixel circuits PXC3 of the second pixel column may be arranged sequentially and/or continuously along the second direction DR2. The pixel circuits PXC of the first pixel column and the pixel circuits PXC of the second pixel column may be adjacent to each other in the first direction DR1.

In FIGS. 7, 8, and 9, only the data lines DL and the first power lines VDL among the power lines PL and the signal lines connected to the pixel circuits PXC are illustrated. The other signal lines and power lines PL may be appropriately disposed according to the structure of the pixel circuits PXC and/or the connection structure or connection direction with the pixel circuits PXC.

For example, the scan lines SL and the emission control lines ECL of FIG. 5 may be disposed in each horizontal line of the display area DA. The scan lines SL and the emission control lines ECL may be arranged in the second direction DR2, and may each extend in the first direction DR1. The positions or arrangement order of the scan lines SL and the emission control lines ECL may vary depending on the design structure of the pixel circuits PXC. For example, the scan lines SL and the emission control lines ECL may be disposed around the circuit elements to which each signal line is connected, and may be formed integrally with a part of the circuit elements, or may be electrically connected to the circuit elements through at least one contact hole and/or connection pattern.

The second power line VSL of FIG. 5 may be disposed inside and/or around the display area DA, and may be electrically connected to the second electrode ET2 of the light emitting element LE inside and/or around the display area DA. Each of the third power line VIL, the fourth power line VAIL, and the fifth power line VOBL of FIG. 5 may be disposed in the display area DA, and may be electrically connected to the pixel circuits PXC. For example, the third power line VIL, the fourth power line VAIL, and the fifth power line VOBL of FIG. 5 may have a shape in which each of them is branched into a plurality of lines in the display area DA, may be arranged in one of the first direction DR1 and the second direction DR2, and may each extend in the other of the first direction DR1 and the second direction DR2. Alternatively, at least one power line PL connected to the sub-pixels SPX may have a mesh shape in the display area DA.

The power lines PL and the signal lines connected to the sub-pixels SPX may each be formed as a single or multilayer wire included in at least one conductive layer included in the backplane layer 120. Accordingly, in the process of forming the pixel circuits PXC, wires connected to the sub-pixels SPX may be formed simultaneously.

FIGS. 7, 8, and 9 show embodiments of the backplane layer 120, and the emission areas EA where the light emitting elements LE on the backplane layer 120 are disposed are inferred. The display panel 100 including the backplane layer 120 according to at least one of the embodiments of FIGS. 7, 8, and 9 may include the emission areas EA arranged in the same or different shape and/or order as the embodiment of FIG. 4. For example, the emission areas EA and the pixel circuits PXC of each pixel PX may be arranged to correspond to each other, or may be arranged independently.

In an embodiment of the present disclosure, even if the pixel circuits PXC of the first pixel PX1 and the pixel circuits PXC of the second pixel PX2 are arranged in different shapes and/or orders, the emission areas EA of the first pixel PX1 and the emission areas EA of the second pixel PX2 may be arranged in the same shape and/or order. For example, even if the pixel circuits PXC of the first pixel PX1 and the pixel circuits PXC of the second pixel PX2 are arranged as in the embodiment of FIG. 7, FIG. 8, or FIG. 9, the emission areas EA of the first pixel PX1 and the emission areas EA of the second pixel PX2 may be arranged in the same shape and/or order as in the embodiment of FIG. 4.

In an embodiment, the emission areas EA of the first pixel PX1 and the emission areas EA of the second pixel PX2 may be arranged in different shapes and/or orders to correspond to the arrangement shapes and/or orders of the pixel circuits PXC of the first pixel PX1 and the pixel circuits PXC of the second pixel PX2. For example, when the pixel circuits PXC of the first pixel PX1 and the pixel circuits PXC of the second pixel PX2 are arranged as in the embodiment of FIG. 8 or 9, the order in which the first and second emission areas EA1 and EA2 and the third emission area EA3 are disposed in the first pixel PX1 with respect to the first direction DR1 may be opposite to the order in which the first and second emission areas EA1 and EA2 and the third emission area EA3 are disposed in the second pixel PX2.

In addition, the emission areas EA of each pixel PX may be arranged in at least one of the first direction DR1 or the second direction DR2. For example, as in the embodiment of FIG. 4, at least two emission areas EA among the emission areas EA of each pixel PX may be arranged sequentially in each of the first direction DR1 and the second direction DR2. Alternatively, the emission areas EA of each pixel PX may be arranged sequentially only in one of the first direction DR1 and the second direction DR2.

In addition to the embodiments described above, the emission areas EA of each pixel PX may be arranged in various shapes and/or orders. In addition, the emission areas EA and the pixel circuits PXC of each pixel PX may overlap each other or might not overlap each other.

The light emitting element LE and the pixel circuit PXC of each sub-pixel SPX may be connected to each other in various ways depending on embodiments. In an embodiment of the present disclosure, when the emission area EA and the pixel circuit PXC of one sub-pixel SPX overlap each other, the light emitting element LE disposed in the emission area EA may be connected to the pixel circuit PXC on the pixel circuit PXC. When the emission area EA and the pixel circuit PXC of one sub-pixel SPX do not overlap each other, at least one connection pattern (for example, at least one of the fourth connection pattern CNE4 or the fifth connection pattern CNE5 of FIG. 6) may be appropriately disposed between the pixel circuit PXC and the light emitting element LE disposed in the emission area EA, and the light emitting element LE and the pixel circuit PXC may be connected by the at least one connection pattern.

In the embodiments of FIGS. 7, 8 and 9, in each unit structure UNA, the same number of the first type pixel circuits PXC_A and the second type pixel circuits PXC_B may be arranged alternately in the first direction DR1. In addition, a pair of the first type pixel circuit PXC_A and the second type pixel circuit PXC_B adjacent to each other in the first direction DR1 may have opposite or symmetrical shapes and may share one first power line VDL. Accordingly, the design structure of the backplane layer 120 may be improved or optimized.

In addition, in the embodiments of FIGS. 7, 8, and 9, among the first sub-pixels SPX1, the second sub-pixels SPX2, and the third sub-pixels SPX3, only the sub-pixels SPX of a specific color may include the first type pixel circuits PXC_A and the second type pixel circuits PXC_B. The sub-pixels SPX of other colors may respectively include the first type or second type pixel circuits PXC_B. Accordingly, even if the overlay is misaligned in the manufacturing process of the display panel 100, the deterioration of the image quality of the display device 1 may be prevented, reduced, or minimized.

Thus, in various embodiments of the pixel circuit arrangements within a display panel's backplane layer, as illustrated in FIGS. 7-9, the display area may be divided into repeating unit structures (UNA), each including a pair of pixels with associated sub-pixel circuits. Different configurations show how pixel circuits (PXC) can be arranged in mirrored or symmetrical layouts, alternating between two types (PXC_A and PXC_B), which can share a common power line (VDL) to optimize space and improve voltage delivery. Despite these variations in circuit layout, the emission areas that produce visible light can be arranged uniformly to maintain consistent image quality. By using symmetrical circuit layouts and assigning consistent circuit types to specific sub-pixels (e.g., red, green, or blue), the designs minimize performance variation caused by manufacturing misalignments, thus helping preserve display uniformity and visual fidelity.

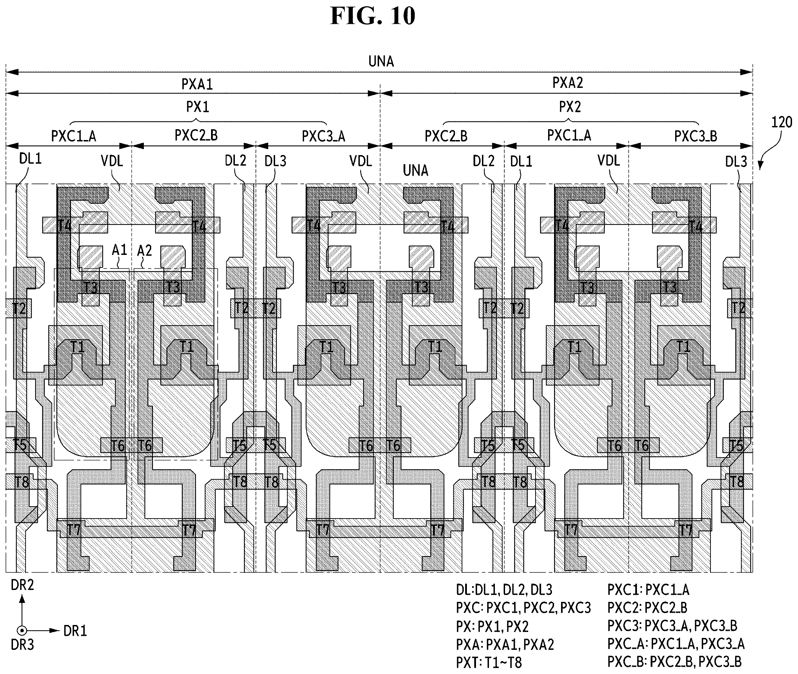

FIG. 10 is a plan view showing a backplane layer of a display panel according to an embodiment of the present disclosure. For example, FIG. 10 shows an embodiment of the present disclosure of the backplane layer 120 in which the alignment error for the patterns of some conductive layers has occurred due to the misalignment of the overlay during the process of forming the backplane layer 120 according to the embodiment of FIG. 7.

Referring to FIG. 10, when the patterns of the conductive layer (for example, the second source-drain conductive layer SCDL2 of FIG. 6) including the data lines DL and the first power lines VDL are formed at positions shifted in the first direction DR1 from the target alignment positions, the operating characteristics of the first type pixel circuits PXC_A and the second type pixel circuits PXC_B may change in different directions. For example, when the first power line VDL1 is shifted to the right side as in FIG. 10 (for example, when the first power line VDL1 is shifted to the right side compared to the patterns included in the first, third, and sixth transistors T1, T3, and T6), the width of area A1 where the first, third, and sixth transistors T1, T3, and T6 of the first type first pixel circuit PXC1_A overlap the first power line VDL may decrease, and the width of area A2 where the first, third, and sixth transistors T1, T3, and T6 of the second type second pixel circuit PXC2_B overlap the first power line VDL may increase. Accordingly, the parasitic capacitance formed in area A1 (for example, the parasitic capacitance formed between the first power line VDL and the node between the first, third, and sixth transistors T1, T3, and T6 of the first type of first pixel circuit PXC1_A) may decrease, and the parasitic capacitance formed in area A2 (for example, the parasitic capacitance formed between the first power line VDL and the node between the first, third, and sixth transistors T1, T3, and T6 of the second type second pixel circuit PXC2_B) may increase. As described above, the operating characteristics of the first type pixel circuits PXC_A and the second type pixel circuits PXC_B may change in different directions.

FIG. 10 illustrates an embodiment in which the patterns of the conductive layer including the data lines DL and the first power lines VDL deviate from the alignment position. However, the alignment error that may occur due to the misalignment of the overlay may appear in various ways. In addition, when the alignment error occurs in the first direction DR1, the operating characteristics of the first type pixel circuits PXC_A and the second type pixel circuits PXC_B may change in different directions.

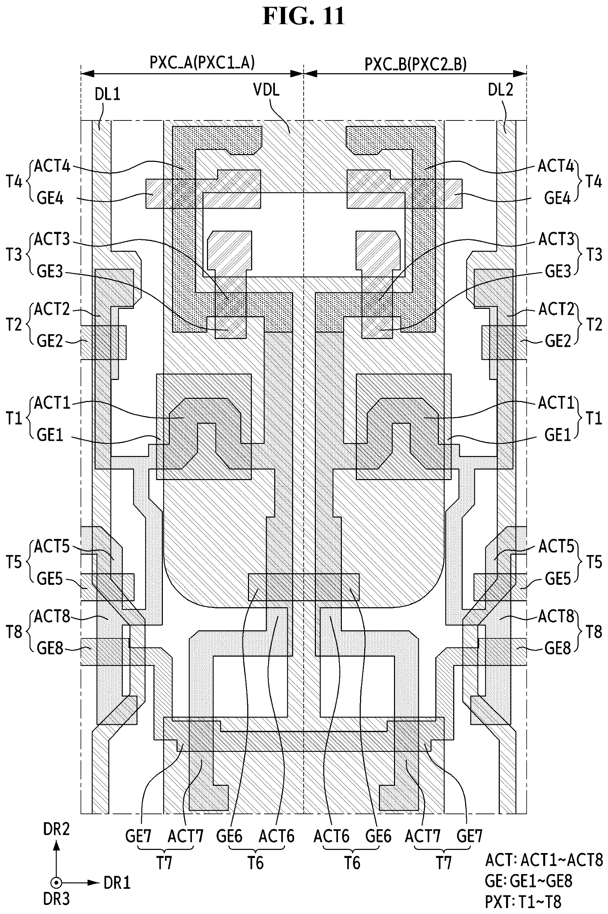

FIG. 11 is a plan view showing a first type pixel circuit and a second type pixel circuit according to an embodiment of the present disclosure. For example, FIG. 11 shows the pixel transistors PXT disposed in a pair of the first type pixel circuit PXC_A and the second type pixel circuit PXC_B adjacent to each other in the first direction DR1 in more detail.

Referring to FIG. 11 in addition to FIGS. 1 to 9, a pair of the first type pixel circuit PXC_A and the second type pixel circuit PXC_B adjacent to each other in the first direction DR1 may have different shapes. FIG. 11 illustrates, as an example of a pair of the first type pixel circuit PXC_A and the second type pixel circuit PXC_B, the first type pixel circuit PXC1_A and the second type pixel circuit PXC2_B adjacent to each other in the first direction DR1.

In an embodiment of the present disclosure, the pixel transistors PXT included in the first type pixel circuit PXC_A and the pixel transistors PXT included in the second type pixel circuit PXC_B may be disposed at opposite or symmetrical positions, and may have substantially symmetrical shapes. For example, the first transistor T1 of the first type pixel circuit PXC_A and the first transistor T1 of the second type pixel circuit PXC_B may have substantially symmetrical shapes with respect to the first power line VDL, and may be disposed at substantially symmetrical positions. In the same manner, in the second transistors T2, the third transistors T3, the fourth transistors T4, the fifth transistors T5, the sixth transistors T6, the seventh transistors T7, and the eighth transistors T8 disposed in the first type pixel circuit PXC_A and the second type pixel circuit PXC_B, the corresponding pixel transistors PXT may have substantially symmetrical shapes with respect to the first power line VDL, and may be disposed at substantially symmetrical positions.

Each pixel transistor PXT may include an active layer ACT, and a gate electrode GE overlapping a part of the active layer ACT. For example, the first transistor T1 may include a first active layer ACT1 and a first gate electrode GE1, and the second transistor T2 may include a second active layer ACT2 and a second gate electrode GE2. The third transistor T3 may include the third active layer ACT3 and the third gate electrode GE3, and the fourth transistor T4 may include the fourth active layer ACT4 and a fourth gate electrode GE4. The fifth transistor T5 may include a fifth active layer ACT5 and a fifth gate electrode GE5, and the sixth transistor T6 may include a sixth active layer ACT6 and a sixth gate electrode GE6. The seventh transistor T7 may include a seventh active layer ACT7 and a seventh gate electrode GE7, and the eighth transistor T8 may include an eighth active layer ACT8 and an eighth gate electrode GE8. Each pixel transistor PXT may be appropriately connected to at least one other circuit element or wire to match the circuit configuration of each pixel circuit PXC. For example, the fifth transistor T5 that does not overlap the first power line VDL may be electrically connected to the first power line VDL through a connection pattern or an additional wire (for example, an additional wire extending in the first direction DR1).

Each active layer ACT may include a channel region overlapping the gate electrode GE of the corresponding pixel transistor PXT, and a source region and a drain region disposed on different sides of the channel region. The source region and the drain region of the active layer ACT may be defined according to the type (for example, P type or N type) of each pixel transistor PXT and the relative level or direction of the electrical signal applied to respective ends of each pixel transistor PXT.

In an embodiment of the present disclosure, the first, second, fifth, sixth, seventh and eighth active layers ACT1, ACT2, ACT5, ACT6, ACT7, and ACT8 may be patterns included in the first semiconductor layer SCL1 of FIG. 6, and the third and fourth active layers ACT3 and ACT4 may be patterns included in the second semiconductor layer SCL2 of FIG. 6. In addition, the first, second, fifth, sixth, seventh and eighth gate electrodes GE1, GE2, GE5, GE6, GE7, and GE8 may be patterns included in the first gate conductive layer GCDL1 of FIG. 6, and the third and fourth gate electrodes GE3 and GE4 may be patterns included in the third gate conductive layer GCDL3 of FIG. 6. In an embodiment of the present disclosure, each of the first type first pixel circuit PXC1_A and the second type second pixel circuit PXC2_B may further include the storage capacitor Cst of FIGS. 5 and 6. In an embodiment of the present disclosure, the storage capacitor Cst may be disposed at a position corresponding to the first transistor T1. For example, the storage capacitor Cst may include the first capacitor electrode SCE1 integral with the first gate electrode GE1, and the second capacitor electrode SCE2 overlapping the first capacitor electrode SCE1, as illustrated in FIG. 6.

In an embodiment of the present disclosure, the active layers ACT included in the first type pixel circuits PXC_A may have the same shape. In addition, the active layers ACT included in the second type pixel circuits PXC_B may have the same shape, and may have a shape different from that of the active layers ACT included in the first type pixel circuits PXC_A. For example, the active layers ACT included in one first type pixel circuit PXC_A and the active layers ACT included in one second type pixel circuit PXC_B adjacent to the one first type pixel circuit PXC_A in the first direction may have opposite shapes in the first direction DR1. For example, among the pixel transistors PXT included in the one first type pixel circuit PXC_A and the pixel transistors PXT included in the one second type pixel circuit PXC_B, the active layers ACT of the pixel transistors PXT corresponding to each other may have opposite shapes or may be disposed at opposite positions in the first direction DR1.

For example, among the active layers ACT of the pixel transistors PXT included in one first type pixel circuit PXC_A and one second type pixel circuit PXC_B sequentially disposed in the first direction DR1, the semiconductor pattern including the first, second, fifth, sixth, seventh and eighth active layers ACT1, ACT2, ACT5, ACT6, ACT7, and ACT8 included in the first type pixel circuit PXC_A and the semiconductor pattern including the first, second, fifth, sixth, seventh and eighth active layers ACT1, ACT2, ACT5, ACT6, ACT7, and ACT8 included in the second type pixel circuit PXC_B may have opposite shapes. In addition, among the active layers ACT of the pixel transistors PXT included in one first type pixel circuit PXC_A and one second type pixel circuit PXC_B sequentially disposed in the first direction DR1, the semiconductor pattern including the third and fourth active layers ACT3 and ACT4 included in the first type pixel circuit PXC_A and the semiconductor pattern including the third and fourth active layers ACT3 and ACT4 included in the second type pixel circuit PXC_B may have opposite shapes.

FIG. 11 illustrates an example of the shape or position of the pixel transistors PXT that may be included in the pixel circuit PXC according to the embodiment of FIG. 5, but the embodiments are not necessarily limited thereto. For example, each pixel circuit PXC may include various shapes, numbers, and/or types of circuit elements according to the configuration of the pixel circuit PXC. In addition, a pair of the first type pixel circuit PXC_A and the second type pixel circuit PXC_B may be designed in substantially symmetrical or opposite shapes. For example, a pair of the first type pixel circuit PXC_A and the second type pixel circuit PXC_B may be designed in substantially symmetrical or opposite shapes with respect to the boundary line between the pair of the first type pixel circuit PXC_A and the second type pixel circuit PXC_B.

Thus, misalignment (e.g., overlay error) occurring during manufacturing may affect the backplane layer of a display panel (100), particularly when pixel circuits of two types (PXC_A and PXC_B) are arranged symmetrically. FIG. 10 illustrates how a shift in conductive layer patterns (e.g., power or data lines) in one direction can alter parasitic capacitance differently in each type of pixel circuit, potentially affecting their performance unevenly. FIG. 11 highlights the symmetry in layout between the two pixel circuit types, showing that their transistors (T1-T8) and associated active and gate layers are mirrored relative to a shared power line. Despite these differences, their shapes are designed to be functionally equivalent, helping to mitigate the visual impact of alignment errors. This symmetrical design ensures consistent electrical behavior across pixels and helps maintain uniform display quality even in the presence of manufacturing variances.

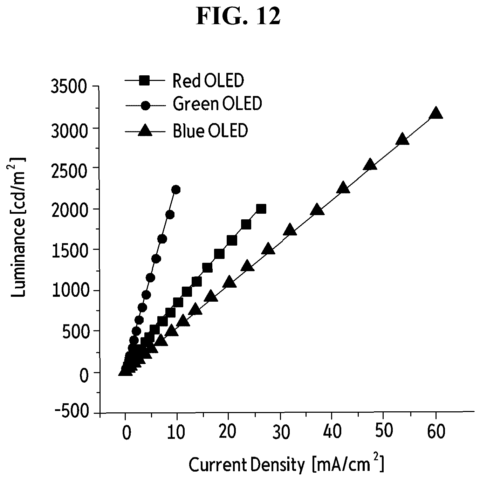

FIG. 12 is a graph showing characteristics of light emitting elements that may be included in a pixel according to an embodiment of the present disclosure. For example, FIG. 12 shows luminance changes according to the current density of a red organic light emitting diode (red OLED), a green organic light emitting diode (green OLED), and a blue organic light emitting diode (blue OLED) that may be included in the first sub-pixel SPX1, the second sub-pixel SPX2, and the third sub-pixel SPX3 of each pixel PX.

Referring to FIG. 12, the change in an amount of luminance of the red organic light emitting diode, the green organic light emitting diode, and the blue organic light emitting diode according to the change in the current density may be different from each other. For example, the green organic light emitting diode may have a greater change in an amount of luminance according to the current density change compared to the red organic light emitting diode and the blue organic light emitting diode. Therefore, the sub-pixel SPX (for example, a green sub-pixel emitting green light) including the green organic light emitting diode may react more sensitively to the change in the driving current Ids compared to the sub-pixel SPX including the red organic light emitting diode or the blue organic light emitting diode. For example, when the driving current Ids of the sub-pixel SPX including the green organic light emitting diode increases, the luminance increase amount of the green organic light emitting diode (or green sub-pixel) due to the increase in the driving current Ids may be relatively large.

The blue organic light emitting diode may have a smaller change in an amount of luminance according to the current density change compared to the red organic light emitting diode and the green organic light emitting diode. For example, the blue organic light emitting diode including a fluorescent light emitting material has lower luminous efficiency than those of the red organic light emitting diode and the green organic light emitting diode including a phosphorescent light emitting material, so that the change in an amount of luminance according to the current density change may be relatively small. Therefore, the sub-pixel SPX including the blue organic light emitting diode (for example, a blue sub-pixel emitting blue light) may be less sensitive to the change in the driving current Ids compared to the sub-pixel SPX including the red organic light emitting diode or the green organic light emitting diode. For example, when the driving current Ids of the sub-pixel SPX including the blue organic light emitting diode increases, the luminance increase amount of the blue organic light emitting diode (or blue sub-pixel) due to the increase in the driving current Ids may be relatively small.

In the embodiments of FIGS. 7 to 11, in one unit structure UNA, the first pixel circuits PXC1 of the same type, the second pixel circuits PXC2 of the same type, and the third pixel circuits PXC3 of different types may be disposed. In the embodiments, the third sub-pixels SPX3 including the third pixel circuits PXC3 may be the sub-pixels that are less sensitive to the change in the driving current Ids compared to the first sub-pixels SPX1 and the second sub-pixels SPX2. For example, one of the first sub-pixels SPX1 and the second sub-pixels SPX2 may be red sub-pixels including red organic light emitting diodes as the respective light emitting elements LE, the other of the first sub-pixels SPX1 and the second sub-pixels SPX2 may be green sub-pixels including green organic light emitting diodes as the respective light emitting elements LE, and the third sub-pixels SPX3 may be blue sub-pixels including blue organic light emitting diodes as the respective light emitting elements LE.

When the light emitting elements LE included in the sub-pixels SPX are the light emitting elements LE of different types or colors, among the light emitting elements LE included in each sub-pixel SPX, the pixel circuits PXC of the sub-pixels SPX of a specific color, which include the light emitting elements LE that are most insensitive to the change in the driving current Ids that may be caused by the misalignment of the overlay, may be selected as the third pixel circuits PXC3. Alternatively, regardless of types or characteristics of the light emitting elements LE, the pixel circuits PXC of the sub-pixels SPX that are most insensitive to the change in the driving current Ids may be selected as the third pixel circuits PXC3 depending on the sensitivity of the sub-pixels SPX according to the change in the driving current Ids.

For example, among the first sub-pixels SPX1 emitting light of the first color, the second sub-pixels SPX2 emitting light of the second color, and the third sub-pixels SPX3 emitting light of the third color, the sub-pixels SPX of a specific color, of which change in an amount of luminance due to the process variation or process error is smallest, may be selected, and the pixel circuits PXC of the sub-pixels SPX may be alternately designed as the first type pixel circuits PXC_A and the second type pixel circuits PXC_B. For example, the sub-pixels SPX including the first type pixel circuits PXC_A and the second type pixel circuits PXC_B may be the first sub-pixels SPX1, the second sub-pixels SPX2, or the third sub-pixels SPX3. On the other hand, the sub-pixels SPX of which change in an amount of luminance due to the process variation or process error is relatively large may be designed to include the pixel circuits PXC of the same type for each sub-pixel SPX of a specific color.

According to the embodiments of FIGS. 7 to 11, the arrangement shape and/or structure of the pixel circuits PXC included in a pair of the first pixel PX1 and the second pixel PX2 may be optimized to alternately arrange the first type pixel circuits PXC_A and the second type pixel circuits PXC_B. For example, in the embodiments of FIGS. 7 to 11, a pair of sub-pixels SPX adjacent to each other in the first direction DR1 may be formed to share the first power line VDL and, at the same time, the backplane layer 120 may be formed such that only sub-pixels SPX (for example, the third sub-pixels SPX3 that are most insensitive to variation in the characteristics of each pixel circuit PXC due to the process error or the like compared to the first and second sub-pixels SPX1 and SPX2) emitting light of a specific color include the first type pixel circuits PXC_A and the second type pixel circuits PXC_B. Accordingly, the design structure of the backplane layer 120 may be improved or optimized while improving or securing the image quality of the display device 1.

In an embodiment of the present disclosure, as illustrated in FIG. 4, in each of the first pixel region PXA1 and the second pixel region PXA2, the first pixel circuit PXC1, the second pixel circuit PXC2, and the third pixel circuit PXC3 are sequentially arranged along the first direction DR1, and a pair of two pixel circuits PXC adjacent to each other in the first direction DR1 are formed in a flipped shape, thereby improving or optimizing the design structure of the backplane layer 120. In this case, in each of the first sub-pixels SPX1, the second sub-pixels SPX2, and the third sub-pixels SPX3, the pixel circuits PXC may be formed as two types of pixel circuits PXC. For example, as in the embodiment of FIG. 4, when the first pixel circuit PXC1, the second pixel circuit PXC2, and the third pixel circuit PXC3 of the first pixel PX1, and the first pixel circuit PXC1, the second pixel circuit PXC2, and the third pixel circuit PXC3 of the second pixel PX2 are sequentially arranged in each unit structure UNA, the first pixel circuit PXC1 of the first pixel PX1 and the first pixel circuit PXC1 of the second pixel PX2 may be formed as the first type pixel circuit PXC_A and the second type pixel circuit PXC_B, respectively, the second pixel circuit PXC2 of the first pixel PX1 and the second pixel circuit PXC2 of the second pixel PX2 may be formed as the second type pixel circuit PXC_B and the first type pixel circuit PXC_A, respectively, and the third pixel circuit PXC3 of the first pixel PX1 and the third pixel circuit PXC3 of the second pixel PX2 may be formed as the first type pixel circuit PXC_A and the second type pixel circuit PXC_B, respectively. However, if the pixel circuits PXC are formed as two types of pixel circuits PXC in each of the first sub-pixels SPX1, the second sub-pixels SPX2, and the third sub-pixels SPX3, when the alignment error occurs in the manufacturing process of the display panel 100, the change direction of the driving current Ids may alternately change in each of the first sub-pixels SPX1, the second sub-pixels SPX2, and the third sub-pixels SPX3. Accordingly, the possibility of image quality degradation due to the process error may increase compared to the embodiments of FIGS. 7, 8, and 9.

Thus, red, green, and blue OLED sub-pixels may respond differently to changes in current density, which can affect display uniformity. Green OLEDs may show the highest sensitivity, with large luminance changes from small current variations, while blue OLEDs, using less efficient fluorescent materials, are the least sensitive. To reduce image quality variation from manufacturing misalignment, the least sensitive sub-pixels (typically blue) are designed to alternate between two pixel circuit types (PXC_A and PXC_B), which helps absorb current variations without visible impact. Red and green sub-pixels, which are more sensitive, are kept consistent to avoid introducing visual inconsistency. This arrangement improves the backplane design and ensures better image quality by minimizing luminance shifts due to overlay errors in production.

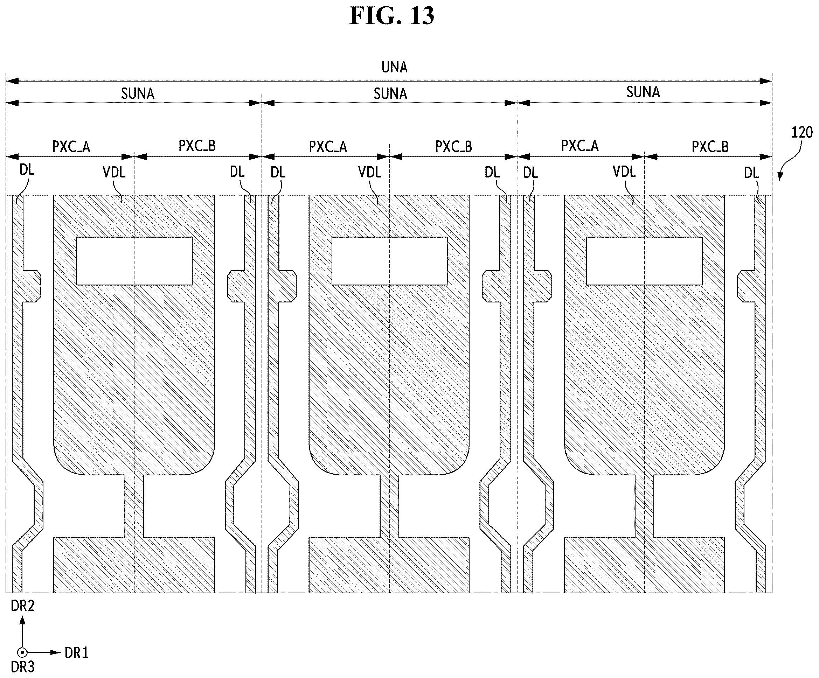

FIG. 13 is a plan view showing data lines and first power lines according to an embodiment of the present disclosure. For example, FIG. 13 shows the data lines DL and the first power lines VDL according to the embodiments of FIGS. 7, 8, and 9.

Referring to FIG. 13 in addition to FIGS. 7, 8, and 9, in an area where a pair of the first type pixel circuit PXC_A and the second type pixel circuit PXC_B adjacent to each other in the first direction DR1 are disposed, at least one first power line VDL and the data lines DL electrically connected to the pair of the first type pixel circuit PXC_A and the second type pixel circuit PXC_B may be disposed. As in the embodiments of FIGS. 7, 8, and 9, when a pair of the first type pixel circuit PXC_A and the second type pixel circuit PXC_B share one first power line VDL, one first power line VDL may be disposed in each sub-unit structure SUNA.

In describing the embodiments, the sub-unit structure SUNA may refer to an area where a pair of the first type pixel circuit PXC_A and the second type pixel circuit PXC_B are disposed. For example, the backplane layer 120 according to the embodiments of FIGS. 7, 8, and 9 may include three sub-unit structures SUNA disposed in each unit structure UNA. The sub-unit structures SUNA may be arranged in the first direction DR1 in each unit structure UNA.

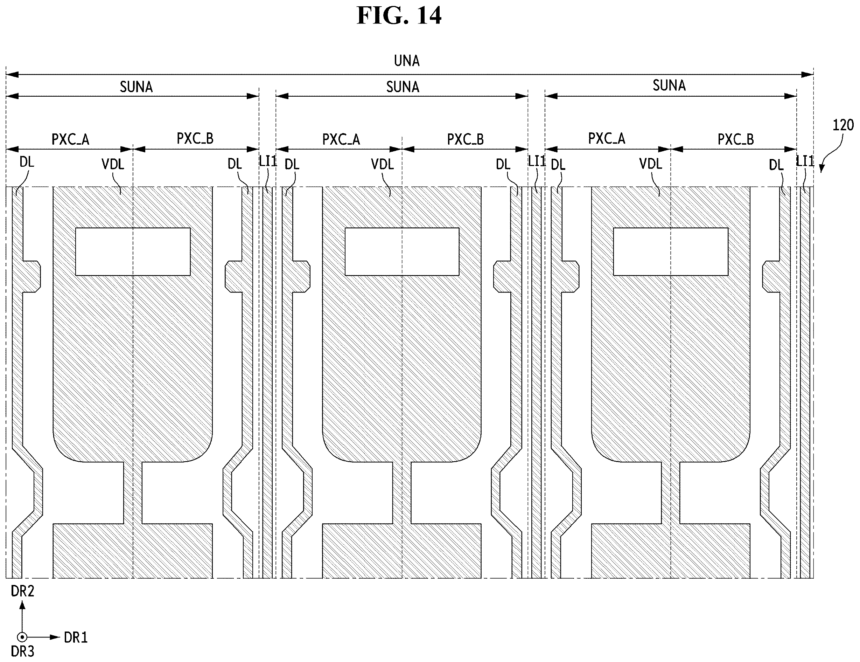

FIG. 14 is a plan view showing data lines, first power lines, and first wires according to an embodiment of the present disclosure. For example, FIG. 14 shows an example of first wires LI1 that may be disposed in the backplane layer 120 together with the data lines DL and the first power lines VDL of FIG. 13 according to an embodiment of the present disclosure.

Referring to FIGS. 13 and 14, the backplane layer 120 may further include the first wires LI1. The first wires LI1 may be arranged in the first direction DR1 in the display area DA, and may each extend in the second direction DR2. Although FIG. 14 illustrates that the first wires LI1 have a straight shape without being bent or curved, the embodiments are not necessarily limited thereto. For example, each of the first wires LI1 may extend entirely or substantially in the second direction DR2, and may have a shape that is partially bent or a shape in which a width changes.

In an embodiment of the present disclosure, each of the first wires LI1 may be disposed between two data lines DL adjacent to each other in the first direction DR1. For example, each of the first wires LI1 may be disposed between two sub-unit structures SUNA adjacent to each other in the first direction DR1, and may be disposed between two data lines DL. Although FIG. 14 illustrates an embodiment in which the first wires LI1 are disposed between the sub-unit structures SUNA, the embodiments are not necessarily limited thereto. For example, at least one of the first wires LI1 may be partially or entirely disposed in at least one sub-unit structure SUNA.

In an embodiment of the present disclosure, the data lines DL, the first power lines VDL, and the first wires LI1 may be formed in patterns of the same conductive layer. For example, by efficiently locating the pixel circuits PXC, the data lines DL, and the first power lines VDL in the backplane layer 120, it is possible to secure a wiring space where the first wires LI1 may be formed in the conductive layer (for example, the second source-drain conductive layer SCDL2 of FIG. 6) including the data lines DL and the first power lines VDL. Accordingly, the first wires LI1 may be appropriately or easily disposed in the secured wiring space.

In an embodiment of the present disclosure, the first wires LI1 may be various types and/or shapes of wires that may be disposed in the display area DA. For example, each of the first wires LI1 may be utilized as the power line PL (for example, one of the second, third, fourth, and fifth power lines VSL, VIL, VAIL, and VOBL of FIG. 4, or a power line to which another constant voltage is applied) electrically connected to the sub-pixels SPX, or may be utilized as a connection line that connects the data lines DL disposed in a part of the display area DA (for example, a left and/or right edge area of the display area DA) to data fan-out lines disposed between the display driver 200 and the display area DA. The first wires LI1 may be wires to which the same type of voltage or signal is applied, or may be wires to which different types of voltages or signals are applied. When a constant voltage is applied to the first wires LI1, the voltage variation of the data lines DL due to a coupling action or the like may be prevented or reduced.

The first wires LI1 may be disposed in all unit structures UNA of the display area DA, or may be disposed only in some unit structures UNA of the display area DA. For example, various numbers, positions, and/or types of first wires LI1 may be disposed in the display area DA as needed. In addition, although FIG. 14 illustrates an embodiment in which one first wire LI1 is disposed between two adjacent data lines DL, the number of the first wires LI1 disposed between two adjacent data lines DL is not necessarily limited thereto.

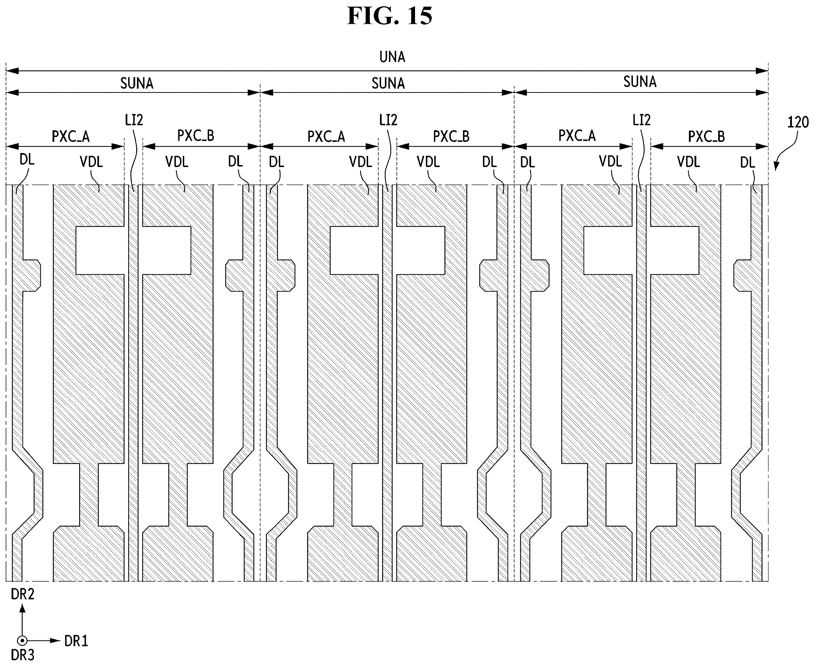

FIG. 15 is a plan view showing data lines, first power lines, and second wires according to an embodiment of the present disclosure. For example, FIG. 15 shows an example of second wires LI2 that may be disposed in the backplane layer 120 together with the data lines DL and the first power lines VDL of FIG. 13 according to an embodiment of the present disclosure.

Referring to FIGS. 13 and 15, the plurality of first power lines VDL may be disposed in each sub-unit structure SUNA. For example, two first power lines VDL including the first power line VDL connected to the first type pixel circuit PXC_A and the second power line VDL connected to the second type pixel circuit PXC_B may be disposed in each sub-unit structure SUNA. The two first power lines VDL may be electrically connected to each other inside the display area DA (for example, the edge area of the display area DA) and/or around the display area DA, but may be separated from each other in each sub-unit structure SUNA. For example, the two first power lines VDL may be spaced apart from each other in the first direction DR1.

The backplane layer 120 may further include the second wires LI2 disposed between the first power lines VDL. For example, the backplane layer 120 may further include the second wires LI2 disposed between two first power lines VDL in the sub-unit structures SUNA.

The second wires LI2 may be arranged in the first direction DR1 in the display area DA, and may each extend in the second direction DR2. Although FIG. 15 illustrates that the second wires LI2 have a straight shape without being bent or curved, the embodiments are not necessarily limited thereto. For example, each of the second wires LI2 may entirely or substantially extend in the second direction DR2, and may have a shape that is partially bent or a shape in which a width changes.

Although FIG. 15 illustrates an embodiment in which the second wires LI2 are disposed between a pair of the first type pixel circuit PXC_A and the second type pixel circuit PXC_B, the embodiments are not necessarily limited thereto. For example, at least one of the second wires LI2 may partially or entirely overlap at least one pixel circuit PXC (for example, the first type pixel circuit PXC_A and/or the second type pixel circuit PXC_B disposed in each sub-unit structure SUNA).

In an embodiment of the present disclosure, the data lines DL, the first power lines VDL, and the second wires LI2 may be formed in patterns of the same conductive layer. For example, by efficiently locating the pixel circuits PXC, the data lines DL, and the first power lines VDL in the backplane layer 120, the second wires LI2 may be appropriately or easily disposed in the conductive layer including the data lines DL and the first power lines VDL.

In an embodiment of the present disclosure, the second wires LI2 may be various types and/or shapes of wires that may be disposed in the display area DA. For example, each of the second wires LI2 may be utilized as the power line PL (for example, one of the second, third, fourth, and fifth power lines VSL, VIL, VAIL, and VOBL of FIG. 4, or a power line to which another constant voltage is applied) electrically connected to the sub-pixels SPX, or may be utilized as a connection line that connects the data lines DL disposed in a part of the display area DA (for example, a left and/or right edge area of the display area DA) to data fan-out lines disposed between the display driver 200 and the display area DA. The second wires LI2 may be wires to which the same type of voltage or signal is applied, or may be wires to which different types of voltages or signals are applied.

The second wires LI2 may be disposed in all unit structures UNA (or all sub-unit structures SUNA) of the display area DA, or may be disposed only in some unit structures UNA (or some sub-unit structures SUNA) of the display area DA. For example, various numbers, positions, and/or types of second wires LI2 may be disposed in the display area DA as needed. In addition, although FIG. 15 illustrates an embodiment in which one second wire LI2 is disposed between two adjacent first power lines VDL, the number of the second wires LI2 disposed between two adjacent first power lines VDL is not necessarily limited thereto.

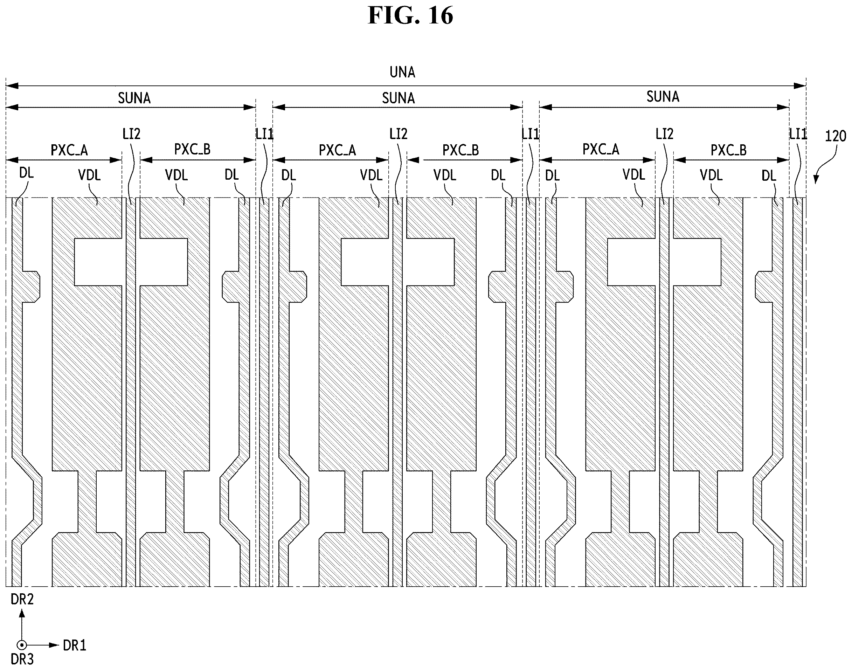

FIG. 16 is a plan view showing data lines, first power lines, first wires, and second wires according to an embodiment of the present disclosure. For example, FIG. 16 shows an example of the first wires LI1 and the second wires LI2 that may be disposed in the backplane layer 120 together with the data lines DL and the first power lines VDL of FIG. 13 according to an embodiment of the present disclosure.

Referring to FIG. 16 in addition to FIGS. 13 to 15, the backplane layer 120 may include both the first wires LI1 and the second wires LI2. For example, the backplane layer 120 may include at least one of the first wires LI1 or the second wires LI2, as needed, as in the embodiment of FIG. 14, FIG. 15 or FIG. 16.

In the embodiments described above, the configuration in which the data lines DL, the first power lines VDL, the first wires LI1 and/or the second wires LI2 are included in the backplane layer 120 has been described, but the embodiments are not necessarily limited thereto. For example, the data lines DL, the first power lines VDL, the first wires LI1 and/or the second wires LI2 may be disposed in at least one conductive layer included in the display panel 100.

Thus, the layout and functionality of data lines, power lines, and auxiliary wiring in the backplane layer of a display panel (100) are defined. In each sub-unit area, pairs of pixel circuits of different types (PXC_A and PXC_B) share or are adjacent to data lines (DL) and first power lines (VDL). Additional wires, such as first wires (LI1) and second wires (LI2), may be included to enhance electrical connectivity and signal stability. These wires can serve various purposes, such as power distribution or signal routing between sub-pixels and the display driver, and are arranged between or near data and power lines. Both LI1 and LI2 wires may be patterned in the same conductive layer as DL and VDL and can vary in shape, position, and quantity depending on design needs. This flexible arrangement helps optimize the wiring layout while maintaining high display performance and reducing voltage fluctuations.

The display device 1, according to at least one of the above-described embodiments, may be applied to various electronic devices 10. An electronic device 10 according to an embodiment of the present disclosure may include the above-described display device 1, and may further include, in addition to the display device 1, a module or device having other additional functions.

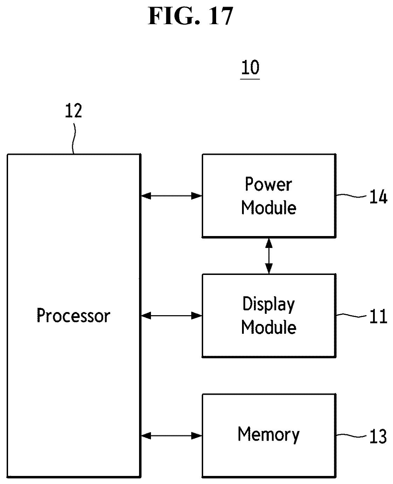

FIG. 17 is a block diagram of an electronic device 10 according to an embodiment of the present disclosure. Referring to FIG. 17, the electronic device 10, according to an embodiment of the present disclosure, may include the display module 11, a processor 12, a memory 13, and a power module 14.

The electronic device 10 may output various information in the form of images through the display module 11. For example, when the processor 12 executes an application stored in the memory 13, image information provided by the application may be provided to a user through the display module 11.

The processor 12 may include at least one of a central processing unit (CPU), an application processor (AP), a graphic processing unit (GPU), a communication processor (CP), an image signal processor (ISP), or a controller.

The memory 13 may store data information required for the operation of the processor 12 or the display module 11. For example, the memory 13 may store an image data signal and/or an input control signal.

The processor 12 may control the display module 11 using information stored in the memory 13. The processor 12 may transmit the image data signal and/or the input control signal stored in the memory 13 to the display module 11. For example, when the processor 12 executes an application stored in the memory 13, an image data signal and/or an input control signal is transmitted to the display module 11, and the display module 11 may process the received signal and output image information through a display screen.

In an embodiment of the present disclosure, the processor 12 may transmit the image data signal corresponding to the arrangement shape or order of the sub-pixels SPX included in the display module 11 to the display module 11. For example, the processor 12 may transmit the image data signal corresponding to the arrangement order of the pixel circuits PXC of the first pixel PX1 and the second pixel PX2 in the unit structure UNA to the display module 11. For example, the processor 12 may convert the image data signal stored in the memory 13 to match the arrangement shape or order of the sub-pixels SPX and transmit it to the display module 11. Accordingly, the display module 11 may appropriately display the image corresponding to the image data signal, and improve the display quality. However, the embodiments are not necessarily limited thereto. For example, in an embodiment, the display driver 200 of the display module 11 may convert the image data signal transmitted from the processor 12 to correspond to the order in which the pixel circuits PXC of the first pixel PX1 and the second pixel PX2 are arranged in the unit structure UNA.

The power module 14 may include a power supply module, such as a power adapter or a battery device, and a power conversion module that converts power supplied by the power supply module to generate power required for the operation of the electronic device 10.

At least one of the components of the electronic device 10 described above may be included in the display device 1 according to the embodiments described above. Further, some of individual modules functionally included in one module may be included in the display device 1 and some others may be provided separately from the display device 1. For example, the display device 1 may include the display module 11, and the processor 12, the memory 13, and the power module 14 may be provided in the form of other devices in the electronic device 10 other than the display device 1.

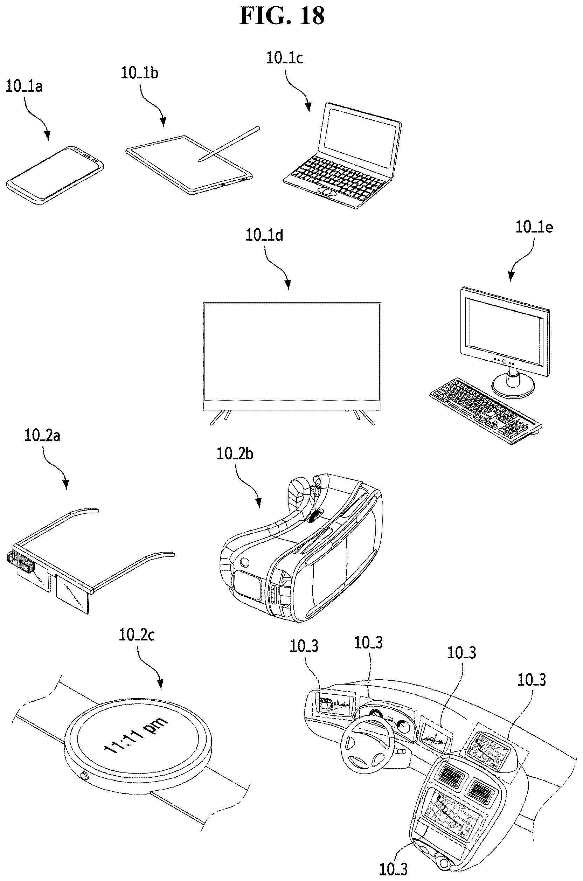

FIG. 18 is schematic views of electronic devices according to various embodiments.

Referring to FIG. 18, various electronic devices 10 to which the display device 1 according to embodiments is applied may include not only an image display electronic device 10 such as a smartphone 10_1a, a tablet computer 10_1b, a laptop/notebook computer 10_1c, a TV 10_1d, and a computer monitor 10_1e, but also a wearable electronic device 10 including a display module 11, such as smart glasses 10_2a, a head mounted display 10_2b, or a smart watch 10_2c, a vehicle electronic device 10_3 including a display module 11, such as a center fascia, and a dashboard of an automobile, a center information display (CID) placed on the dashboard, a room mirror display, and the like.

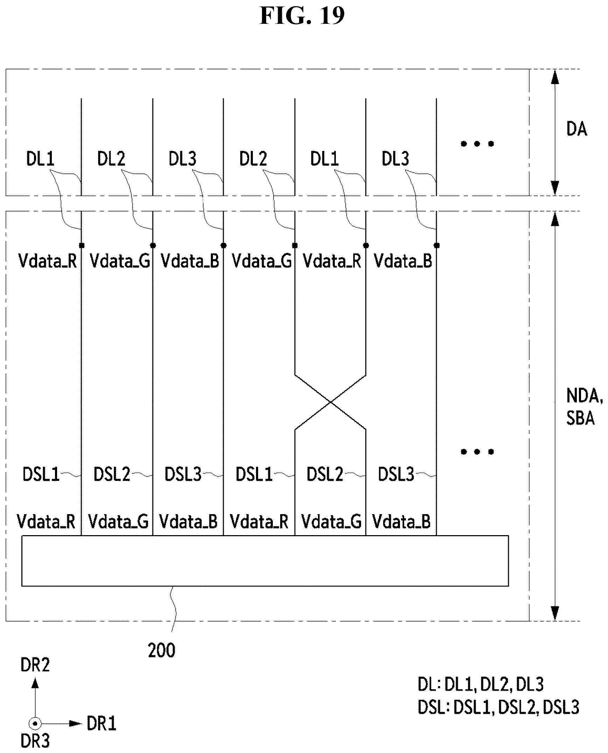

FIG. 19 is a plan view schematically showing a connection structure of a display driver and data lines according to an embodiment of the present disclosure.

Referring to FIG. 19, the data lines DL and the display driver 200 may be electrically connected to each other through data connection lines DSL (for example, data spider lines). In an embodiment of the present disclosure, the data lines DL may extend to the non-display area NDA under the display area DA, and may be connected to the respective data connection lines DSL through at least one contact hole and/or connection wire in the non-display area NDA. However, the embodiments are not necessarily limited thereto, and the connection structure between the data lines DL and the display driver 200 may vary depending on embodiments. For example, in an embodiment, the locations where the data lines DL and the data connection lines DSL are connected may be changed, or at least one pair of the data line DL and the data connection line DSL may be formed integrally.

FIG. 19 illustrates, as an example of the data lines DL, the data lines DL electrically connected to the sub-pixels SPX included in a pair of the first pixel PX1 and the second pixel PX2. The data lines DL may be arranged in the first direction DR1, and may each extend in the second direction DR2.

The display driver 200 may output the data voltage Vdata corresponding to each of the sub-pixels SPX to the data connection lines DSL. For example, the display driver 200 may output a first data voltage Vdata_R corresponding to each of the first sub-pixels SPX1 to first data connection lines DSL1 connected to the first data lines DL1 connected to the first sub-pixels SPX1 of each pixel column. In addition, the display driver 200 may output a second data voltage Vdata_G corresponding to each of the second sub-pixels SPX2 to second data connection lines DSL2 connected to the second data lines DL2 connected to the second sub-pixels SPX2 of each pixel column, and may output a third data voltage Vdata_B corresponding to each of the third sub-pixels SPX3 to third data connection lines DSL3 connected to the third data lines DL3 connected to the third sub-pixels SPX3 of each pixel column.

The data connection lines DSL may be connected between the display driver 200 and the data lines DL, and may be arranged in the first direction DR1. In an embodiment of the present disclosure, the data connection lines DSL may be arranged around the display driver 200 in the order in which the first data voltage Vdata_R, the second data voltage Vdata_G, and the third data voltage Vdata_B are outputted from the display driver 200. In addition, the data connection lines DSL may be arranged around the data lines DL and/or the display area DA in the arrangement order of the data lines DL.

For example, as in the embodiment of FIG. 7, in case that the data lines DL connected to a pair of the first pixel PX1 and the second pixel PX2 are arranged in the order of the first data line DL1, the second data line DL2, and the third data line DL3 of the first pixel PX1, and the second data line DL2, the first data line DL1, and the third data line DL3 of the second pixel PX2 in the first direction DR1, the first data connection line DSL1 and the second data connection line DSL2 connected to the first data line DL1 and the second data line DL2 of the second pixel PX2 intersect once while connecting from the display driver 200 to the respective data lines DL, so that the arrangement order in the first direction DR1 may be changed. By locating at least one insulating layer between the data connection lines DSL intersecting each other at a point where at least two data connection lines DSL intersect, the electrical stability may be ensured. According to the embodiment described above, the data voltages Vdata outputted from the display driver 200 may be appropriately transmitted to the respective data lines DL.

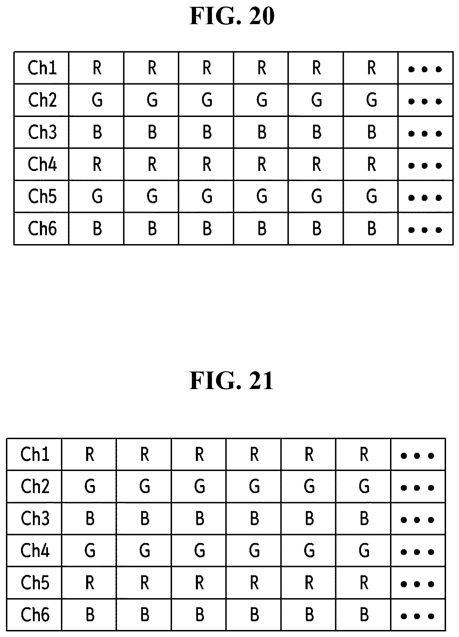

FIG. 20 shows a method of transmitting an image data signal according to an embodiment of the present disclosure.

Referring to FIG. 20, the processor 12 of the electronic device 10 (or the display device 1) may output the image data signal corresponding to the first sub-pixel SPX1, the second sub-pixel SPX2, and the third sub-pixel SPX3 of each pixel PX to each data channel regardless of the arrangement order (or arrangement shape) of the data lines DL. For example, the processor 12 may output a first image data signal R corresponding to the first sub-pixel SPX1 of the first pixel PX1, a second image data signal G corresponding to the second sub-pixel SPX2 of the first pixel PX1, a third image data signal B corresponding to the third sub-pixel SPX3 of the first pixel PX1, a first image data signal R (or a fourth image data signal) corresponding to the first sub-pixel SPX1 of the second pixel PX2, a second image data signal G (or a fifth image data signal) corresponding to the second sub-pixel SPX2 of the second pixel PX2, and a third image data signal B (or a sixth image data signal) corresponding to the third sub-pixel SPX3 of the second pixel PX2 to a first data channel Ch1, a second data channel Ch2, a third data channel Ch3, a fourth data channel Ch4, a fifth data channel Ch5, and a sixth data channel Ch6, respectively. The processor 12 may output each image data signal to each data channel at each refresh cycle (for example, at each frame).

In an embodiment of the present disclosure, the display driver 200 (or a timing controller that is provided separately from the display driver 200 and controls the display driver 200) of the display module 11 may output the respective data voltages Vdata to the data connection lines DSL in response to the image data signal transmitted from the processor 12. In this case, by changing the arrangement order of the data connection lines DSL at least once as illustrated in FIG. 19, the data voltages Vdata outputted from the display driver 200 may be appropriately transmitted to the respective data lines DL.

In an embodiment, the display driver 200 (or a timing controller that is provided separately from the display driver 200 and controls the display driver 200) may rearrange the image data signal transmitted from the processor 12 according to the arrangement order of the data lines DL, and may output the respective data voltages Vdata to the data connection lines DSL based on the rearranged image data signal. In this case, the data connection lines DSL may be arranged consistently in the same order as the data lines DL without changing the arrangement order of the data connection lines DSL, and the data connection lines DSL might not intersect each other.

FIG. 21 shows a method of transmitting an image data signal according to an embodiment of the present disclosure.

Referring to FIG. 21, the processor 12 of the electronic device 10 (or the display device 1) may rearrange the image data signal in the order corresponding to the arrangement order (or arrangement shape) of the data lines DL, and may output the rearranged image data signal to each data channel. For example, the processor 12 may output the first image data signal R corresponding to the first sub-pixel SPX1 of the first pixel PX1, the second image data signal G corresponding to the second sub-pixel SPX2 of the first pixel PX1, the third image data signal B corresponding to the third sub-pixel SPX3 of the first pixel PX1, the second image data signal G (or the fifth image data signal) corresponding to the second sub-pixel SPX2 of the second pixel PX2, the first image data signal R (or the fourth image data signal) corresponding to the first sub-pixel SPX1 of the second pixel PX2, and the third image data signal B (or the sixth image data signal) corresponding to the third sub-pixel SPX3 of the second pixel PX2 to the first data channel Ch1, the second data channel Ch2, the third data channel Ch3, the fourth data channel Ch4, the fifth data channel Ch5, and the sixth data channel Ch6, respectively. In this case, the display driver 200 (or a timing controller that is provided separately from the display driver 200 and controls the display driver 200) may output the data voltage Vdata corresponding to each image data signal without rearranging the image data signal according to the arrangement order of the data lines DL. In addition, the data connection lines DSL may be arranged consistently in the same order as the data lines DL, and might not intersect each other.

Thus, image data signals may be transmitted from a processor to a display panel (100) via a display driver and data connection lines (DSL). Each sub-pixel (red, green, blue) may receive a corresponding data voltage (Vdata) from the display driver, which is routed through data lines (DL) that may connect to the driver via intermediate spider-like connection lines. The layout may vary and in some embodiments, DSLs may intersect and require insulating layers to prevent interference. In other embodiments, data signals may be pre-arranged by either the processor or display driver to match the layout of the data lines, avoiding intersections. The system may accordingly ensure that despite complex routing or varying pixel arrangements, each sub-pixel receives the correct voltage, maintaining consistent image output.

In concluding the detailed description, those skilled in the art will appreciate that many variations and modifications can be made to the embodiments without substantially departing from the technical scope of the present invention as defined by the appended claims.

## Claims

1. A display panel (100), comprising:
a unit structure (UNA) comprising a first pixel region (PXA1) and a second pixel region (PXA2), sequentially arranged in a first direction (DR1) and comprising a first pixel (PX1) and a second pixel (PX2), respectively; and
each of the first pixel (PX1) and the second pixel (PX2) comprising a first sub-pixel (SPX1) that comprises a first pixel circuit (PXC1) of a first type (PXC_A) and emits light of a first color, a second sub-pixel (SPX2) that comprises a second pixel circuit (PXC2) of a second type (PXC_B) and emits light of a second color, and a third sub-pixel (SPX3) that comprises a third pixel circuit (PXC3) of the first type (PXC_A) or the second type (PXC_B), and emits light of a third color;
wherein in the unit structure (UNA), the first type of pixel circuit (PXC_A) and the second type of pixel circuit (PXC_B) are arranged alternately in the first direction (DR1), and
wherein the first type of pixel circuit (PXC_A) and the second type of pixel circuit (PXC_B) have symmetrical shapes.

2. The display panel (100) of claim 1, further comprising a power line (VDL) shared by a pair of the first type of pixel circuit (PXC_A) and the second type of pixel circuit (PXC_B) that are adjacent to each other in the first direction (DR1),
wherein the pair of the first type of pixel circuit (PXC_A) and the second type of pixel circuit (PXC_A) have a symmetrical shape with respect to the power line (VDL).

3. The display panel (100) of claim 1 or 2, further comprising:
a first data line (DL1) and a second data line (DL2) connected to the first type pixel circuit (PXC_A) and the second type pixel circuit (PXC_B), respectively, of a pair of the first type pixel circuit (PXC_A) and the second type pixel circuit (PXC_B) adjacent to each other in the first direction (DR1); and
a power line (VDL) disposed between the first data line (DL1) and the second data line (DL2),
wherein the first data line (DL1) and the second data line (DL2) face each other with the power line (VDL) interposed therebetween.

4. The display panel (100) of any one of the preceding claims, wherein each of the first sub-pixel (SPX1) of the first pixel (PX1) and the second pixel (PX2) further comprises a light emitting element (LE) of the first color, which emits the light of the first color,
wherein each of the second sub-pixel (SPX2) of the first pixel (PX1) and the second pixel (PX2) further comprises a light emitting element (LE) of the second color, which emits the light of the second color, and
wherein each of the third sub-pixel (SPX3) of the first pixel (PX1) and the second pixel (PX2) further comprises a light emitting element (LE) of the third color, which emits the light of the third color.

5. The display panel (100) of any one of the preceding claims, wherein the light of the first color is red light,
wherein the light of the second color is green light, and
wherein the light of the third color is blue light.

6. The display panel (100) of any one of the preceding claims, wherein an amount of luminance change of each of the third sub-pixel (SPX3) of the first pixel (PX1) and the second pixel (PX2), according to a change in driving current (Ids), is smaller than an amount of luminance change of each of the first sub-pixel (SPX1) and the second sub-pixel (SPX2) of the first pixel (PX1) and the second pixel (PX2), according to a change in driving current (Ids).

7. The display panel (100) of any one of the preceding claims, wherein the pixel circuit of the first pixel (PXC1) and the second pixel (PXC2) are arranged in the first direction (DR1).

8. The display panel (100) of any one of the preceding claims, wherein an order of arrangement of the first pixel circuit (PXC1) of the first type (PXC_A) and the second pixel circuit (PXC2) of the second type (PXC_B), of the first pixel (PX1), is different from or the same as an order of arrangement of the first pixel circuit (PXC1) of the first type (PXC_A) and the second pixel circuit (PXC2) of the second type (PXC_B), of the second pixel (PX2).

9. The display panel (100) of any one of the preceding claims, wherein the third pixel circuit (PXC3) of the first type (PXC_A) of the first pixel (PX1) is adjacent to the second pixel circuit (PXC2) of the second type of the second pixel (PX2) or the third pixel circuit (PXC3) of the second type (PXC_B) of the second pixel (PX2).

10. The display panel (100) of any one of the preceding claims, wherein in the first pixel region (PXA1), the first pixel circuit (PXC1) of the first type (PXC_A), the second pixel circuit (PXC2) of the second type (PXC_B), and the third pixel circuit (PXC3) of the first type (PXC_A) are sequentially arranged along the first direction (DR1), and wherein:
in the second pixel region (PXA2), the second pixel circuit (PXC2) of the second type (PXC_B), the first pixel circuit (PXC1) of the first type (PXC_A), and the third pixel circuit (PXC3) of the second type (PXC_B) are sequentially arranged along the first direction (DR1); or
in the second pixel region (PXA2), the third pixel circuit (PXC3) of the second type (PXC_B), the first pixel circuit (PXC1) of the first type (PXC_A), and the second pixel circuit (PXC2) of the second type (PXC_B) are sequentially arranged along the first direction (DR1).

11. The display panel (100) of any one of the preceding claims, further comprising:
data lines (DL) electrically connected to the first type of pixel circuit (PXC_A) and the second type of pixel circuit (PXC_B); and
a first wire (LI1) disposed between a pair of data lines (DL) adjacent in the first direction (DR1), among the data lines (DL).

12. The display panel (100) of any one of the preceding claims, further comprising:
a pair of first power lines (VDL) connected to a pair of the first type pixel circuit (PXC_A) and the second type pixel circuit (PXC_B) adjacent to each other in the first direction (DR1); and
a second wire (LI2) disposed between the pair of first power lines (VDL).

13. The display panel (100) of any one of the preceding claims, wherein each of the first type of pixel circuits (PXC_A) and the second type of pixel circuits (PXC_B) comprises a transistor (T) and a capacitor (Cst).

14. An electronic device (10), comprising:
a display module (11) comprising a display panel (100) of any one of the preceding claims;
a memory (13) storing an image data signal or input control signal; and
a processor (12) transmitting the image data signal or input control signal stored in the memory (13) to the display module (11).

15. The electronic device (10) of claim 14, wherein the display panel (100) further comprises data lines (DL) electrically connected to a corresponding sub-pixel (SPX) of the first pixel (PX1) and the second pixel (PX2) and arranged in the first direction (DR1), and
wherein the processor (12) is configured to transmit image data signals rearranged in an order corresponding to an order of arrangement of the data lines (DL) to the display module (11).
